(19) Europäisches Patentamt
European Patent Office
Office européen des brevets

(11) EP 1 715 373 A1

(12) **EUROPEAN PATENT APPLICATION**
published in accordance with Art. 158(3) EPC

(43) Date of publication:
**25.10.2006 Bulletin 2006/43**

(21) Application number: **05709787.5**

(22) Date of filing: **04.02.2005**

(51) Int Cl.:
***G02F 1/1339*** *(2006.01)*

(86) International application number:
**PCT/JP2005/001722**

(87) International publication number:
**WO 2005/076060 (18.08.2005 Gazette 2005/33)**

(84) Designated Contracting States:
**DE GB NL**

(30) Priority:
**10.02.2004 JP 2004034132**
**10.02.2004 JP 2004034133**
**14.09.2004 JP 2004267487**
**14.09.2004 JP 2004267488**
**21.09.2004 JP 2004274263**
**21.09.2004 JP 2004274264**
**21.09.2004 JP 2004274265**
**21.09.2004 JP 2004274266**
**24.09.2004 JP 2004278486**
**24.12.2004 JP 2004374300**
**27.12.2004 JP 2004377658**
**05.01.2005 JP 2005000816**

(71) Applicant: **SEKISUI CHEMICAL CO., LTD.**
**Osaka-shi,**
**Osaka 530-8565 (JP)**

(72) Inventors:
- **SUEZAKI, Minoru, c/o Sekisui Chemical Co., Ltd.**
  **Mishima-gun, Osaka 618-8589 (JP)**
- **NISHIMURA, Yoshio, c/o Sekisui Chemical Co., Ltd.**
  **Mishima-gun, Osaka 618-8589 (JP)**
- **SHIMIZU, Tatsuhiko, c/o Sekisui Chemical Co., Ltd**
  **Mishima-gun, Osaka 618-8589 (JP)**
- **KOBAYASHI, Sayaka, c/o Sekisui Chemical Co., Ltd.**
  **Mishima-gun, Osaka618 -8589 (JP)**
- **TAKAHASHI, Toru, c/o Sekisui Chemical Co., Ltd.**
  **Koka-shi, Shiga 528-8585 (JP)**

(74) Representative: **HOFFMANN EITLE**
**Patent- und Rechtsanwälte**
**Arabellastraße 4**
**81925 München (DE)**

(54) **COLUMN SPACER, LIQUID CRYSTAL DISPLAY ELEMENT AND CURABLE RESIN COMPOSITION FOR COLUMN SPACER**

(57) An object of the present invention is to provide the column spacer capable of forming a liquid crystal display element which does not produce the color irregularity due to gravity defect and the cold bubbling and exhibits the high durability when the column spacer is used as a spacer for maintaining a gap between two glass substrates at a constant distance in a liquid crystal display element, the liquid crystal display element using the column spacers and the curable resin composition for column spacers from which the column spacer can be produced.
The present invention is directed a column spacer for maintaining a gap between two glass substrates at a constant distance in a liquid crystal display element, which comprises an elastic modulus of 0.2 to 1.0 GPa in compressing by 15% at 25˚C.

EP 1 715 373 A1

## Description

### TECHNICAL FIELD

The present invention relates to a column spacer capable of forming a liquid crystal display which does not produce color irregularity due to gravity defect and cold bubbling and has high durability when the column spacer is used as a spacer for maintaining a gap between two glass substrates at a constant distance in a liquid crystal display element, a liquid crystal display element using the column spacer and a curable resin composition for column spacers from which the column spacer can be produced.

### BACKGROUND ART

Generally, a liquid crystal display element includes a spacer for maintaining a gap between two glass substrates at a constant distance and in addition to this it is composed of a transparent electrode, a polarizer and an alignment layer for aligning a liquid crystal material. At present, as a spacer, there is mainly used a fine particle spacer having a particle diameter of about several micrometers. But, in conventional methods of producing a liquid crystal display element, since fine particle spacers are spread on a substrate in a random fashion, there might be cases where the fine particle spacer was located within a pixel portion. If there is the fine particle spacer within the pixel portion, there is a problem that light may leak due to the irregular alignment of liquid crystal around the spacer and the contrast of an image may be deteriorated, and image quality may be degraded. On this situation, there are studied such various method that the fine particle spacer is not located within the pixel portion, but any method is of complicated operation and of low practical use.

And, in recent years, there has been proposed a One Drop Fill technology (ODF technology) to increase the productivity of the liquid crystal display element. This technology is a method of producing liquid crystal display elements in which a predetermined amount of liquid crystal is added dropwise onto one side of a glass substrate, by which liquid crystal is encapsulated, and the other substrate for a liquid crystal panel is opposed in a state of maintaining a predetermined cell gap between these substrates in a vacuum and bonded. Since according to this method, encapsulating of the liquid crystal is easy compared with the previous methods even when the liquid crystal display element has a larger area and the cell gap becomes narrower, it is believed that the ODF technology will be mainstream of a production method of the liquid crystal display element in the future.
But, when the fine particle spacers are employed in the ODF technology, a problem that the fine particle spacers scattered are streamed with flow of the liquid crystals in dispensing liquid crystals or in bonding opposed substrates and the distribution of the fine particle spacers on a substrate becomes uneven arise. When the distribution of the fine particle spacers becomes uneven, there was a problem that variations in the cell gaps of a liquid crystal cell resulted and color irregularity was produced in liquid crystal display.

On this problem, a column spacer, in which convex patterns for maintaining a cell gap evenly are formed on a substrate for liquid crystals by a technique of photolithography in place of the conventional fine particle spacers, has been proposed and become into practical use (such as Patent document No. 1, Patent document No. 2 and Patent document No. 3). When the column spacer is employed, it is possible to resolve a problem of locating a spacer within a pixel portion or a problem of scattering the spacers unevenly in the ODF technology.

However, in a large liquid crystal display manufactured by the ODF technology using column spacers, there may be cases where a defect referred to as "gravity defect", in which liquid crystals in a liquid crystal cell flow downward during using a display and thereby the color irregularity is produced between an upper half-screen and a lower half-screen, may occur and this became a large problem.

It is conceivable that such "gravity defect" can be resolved by adapting the column spacer in such a way that the column spacer, compressed once, can follow the change of a cell gap through the elastic recovery from a deformation by compression when the liquid crystal in the liquid crystal cell is expanded by heat generated by a backlight and push the cell gap wider not to produce a gap between the substrate and the column spacer. But; in conventional methods, it is necessary to make the resin for forming column spacers resistant to the occurrence of plastic deformation in compression by highly crosslinking the resin in order to provide a large force recovering from deformation for column spacers, but the resin having such a highly crosslinked structure generally tends to have a high compression modulus of elasticity and become hard. When the column spacers are formed from such a hard resin, in a process of deforming column spacers by compressing, a large pressure will be required, and in the obtained liquid crystal display element, a large force of the compressed column spacer to push a liquid crystal cell wider will be contained. When such a force of the column spacer to push a liquid crystal cell wider is large, there was a problem that when the volume contraction of liquid crystal in a liquid crystal cell occurs at low temperatures, this causes a phenomenon, referred to as "cold bubbling", that an internal pressure of the liquid crystal cell decreases sharply to cause and bubbles develop.

Patent Document No. 1:Japanese Kokai Publication Hei-11-133600
Patent Document No. 2:Japanese Kokai Publication 2001-91954
Patent Document No. 3:Japanese Kokai Publication 2001-106765

DISCLOSURE OF THE INVENTION

PROBLEMS WHICH THE INVENTION IS TO SOLVE

In view of the above state of the art, the present invention aims to provide a column spacer capable of forming a liquid crystal display element which does not produce color irregularity due to gravity defect and cold bubbling and has high durability when the column spacer is used as a spacer for maintaining a gap between two glass substrates at a constant distance in a liquid crystal display element, a liquid crystal display element using the column spacer and a curable resin composition for column spacer from which the column spacer can be produced.

MEANS FOR SOLVING THE OBJECT

The present invention pertains to a column spacer for maintaining a gap between two glass substrates at a constant distance in a liquid crystal display element, which comprises an elastic modulus of 0.2 to 1.0 GPa in compressing by 15% at 25˚C.
The present invention pertains to a column spacer for maintaining a gap between two glass substrates at a constant distance in a liquid crystal display element, which comprises a linear expansion coefficient of $1\times10^{-4}$ to $5\times10^{-4}$/˚C at a temperature range of 25 to 100˚C.
Hereinafter, the present invention will be described in detail.
It is thought that a phenomenon of gravity defect occurs by a mechanism that a liquid crystal in a liquid crystal cell is expanded by heat generated by a backlight and push a cell gap wider and in this time a substrate on one side, to which the column spacer is not bonded directly, is lifted away from the column spacer and liquid crystals corresponding to a volume lost the retention by the column spacer flow downward by the gravity. The present inventors made intense investigations, and consequently found that the phenomenon of gravity defect did not occur in a liquid crystal display element in which a column spacer having the high ability to recover from a deformation by compression, flexibility and low elastic modulus was used and a height of this column spacer was designed to be slightly higher than that of a cell gap. The reason for this is assumed to be that in the liquid crystal display thus designed, since the column spacer between the substrates is always going to recover from a state of being compressed through the elasticity, the substrate is not lifted away from the column spacer even when the liquid crystal in the liquid crystal cell is expanded and is going to push a cell gap wider.
In the column spacer of the present invention, an elastic modulus in compressing by 15% at 25˚C has a lower limit of 0.2 GPa and an upper limit of 1.0 GPa. When the elastic modulus is less than 0.2 GPa, the column spacer is too soft to retain the cell gap, and when it is more than 1.0 GPa, since the column spacer is too hard, it penetrates into a color filter layer in bonding the substrates or it cannot attain a sufficient elastic deformation required for recovering from deformation. A preferable lower limit is 0.3 GPa and a preferable upper limit is 0.9 GPa, and a more preferable lower limit is 0.5 GPa and a more preferable upper limit is 0.7 GPa.
Further, in the present description, the term compressing by 15% refers to compressing in such a way that the rate of change of height of a column spacer becomes 15%. And, the elastic modulus is measured by the following method. That is, first, the column spacer formed on the substrate is compressed at a load application rate of 10 mN/s until its height reaches 85% of its initial height, and a load of 85% height is taken as F. Next, after this load F is held for 5 seconds to cause deformation in the column spacer at constant load, the load is removed at a load application rate of 10 mN/s, and the elastic modulus E can be determined from the following equation (2):

$$E = F/(D\times S) \qquad (2),$$

In equation (2), F represents a load (N), D represents the rate of change of a column spacer height and S represents a cross-sectional area of the column spacer ($m^2$).
In the column spacer of the present invention, an elastic modulus in compressing by 15% at 60˚C has a preferable lower limit of 0.13 GPa and a preferable upper limit of 0.65 GPa. Since the elastic modulus of the column spacer of the present invention in compressing by 15% at 60˚C is within this range, the substrate is not lifted away from the column spacer and the occurrence of the gravity defect can be prevented even when an internal temperature of the liquid crystal cell becomes about 60˚C due to the heat generated by a backlight and the liquid crystal is expanded and

a force to push a cell gap wider is generated. When the elastic modulus is less than 0.13 GPa, there may be cases where the column spacer is too soft to retain the cell gap, and when it is more than 0.65 GPa, there may be cases where the column spacer is too hard to attain a sufficient elastic deformation required for recovering from deformation. A more preferable lower limit is 0.2 GPa and a more preferable upper limit is 0.6 GPa.

In producing the column spacers of the present invention, the column spacer is necessarily bonded by thermo-compression at elevated temperatures of about 120˚C in the step of curing a sealing agent for liquid crystal display elements during encapsulating liquid crystal between two glass substrates combined. Therefore, the column spacers of the present invention can preferably exert a certain elastic characteristics even when being bonded by thermo-compression at 120˚C.

In the column spacer of the present invention, an elastic modulus in compressing by 15% at 120˚C has a preferable lower limit of 0.1 GPa and a preferable upper limit of 0.5 GPa. When the elastic modulus is less than 0.1 GPa, there may be cases where the column spacer is too soft to retain the cell gap, and when it is more than 0.5 GPa, there may be cases where the column spacer is too hard to attain a sufficient elastic deformation required for recovering from deformation. A more preferable lower limit is 0.12 GPa and a more preferable upper limit is 0.36 GPa.

In the column spacer of the present invention, when a compression test of compressing by 15% at 25˚C is performed repeatedly, the rate of change of an elastic modulus in the fifth compression relative to an elastic modulus in the first compression is preferably 5% or less. If the rate of change is more than 5%, the elastic modulus of the column spacer is changed by a large amount and the color irregularity due to gravity defect and the cold bubbling are produced when stress is repeatedly applied to the column spacer due to routine uses of a liquid crystal display element. The rate of change is more preferably 4% or less.

In addition, the above rate of change of an elastic modulus can be determined from the following equation (3) when the elastic modulus in the first compression is taken as $E_1$ and the elastic modulus in the fifth compression is taken as $E_5$.

$$\text{Rate of change } C = \{(E_5-E_1)/E_1\}\times 100 \qquad (3)$$

In such a column spacer of the present invention, the elastic modulus $E_5$ in the above fifth compression has a preferable lower limit of 0.2 GPa and a preferable upper limit of 1.0 GPa. When the elastic modulus $E_5$ is less than 0.2 GPa, there may be cases where the column spacer is too soft to retain the cell gap, and when it is more than 1.0 GPa, since the column spacer is too hard, there may be cases where it penetrates into a color filter layer in bonding the substrates or it cannot attain a sufficient elastic deformation required for recovering from deformation. A more preferable lower limit is 0.3 GPa and a more preferable upper limit is 0.9 GPa, and a furthermore preferable lower limit is 0.5 GPa and a furthermore preferable upper limit is 0.7 GPa.

The column spacer is bonded by thermo-compression in encapsulating liquid crystal between two glass substrates in usual production of liquid crystal display elements at elevated temperatures of about 120˚C in order to cure a sealing agent. Therefore, in order to prevent the gravity defect or the cold bubbling surely, it is important to use the column spacers which are low in a change in elastic characteristics even when being bonded by thermo-compression at such elevated temperatures. In the column spacer of the present invention, it is preferred that an initial compression elastic modulus $E_{25}$ in compressing by 15% at 25˚C and a compression elastic modulus $E_{120}$ in compressing by 15% at 25˚C after compressing by 15% at 120˚C satisfy the relationship of the following equation (1) :

$$\{(E_{120}-E_{25})/E_{25}\}\times 100 \leq 10 \qquad (1).$$

Here, the term "initial" refers to a state of about 120˚C not having a history of thermo compression bonding.

In the column spacer of the present invention, the rate of recovery in deforming by compressing by 15% at 25˚C has a preferable lower limit of 70%. When the rate of recovery is less than 70%, a force of the obtained column spacer to recover between substrates of the liquid crystal display is too low and there may be cases where a sufficient effect of inhibiting gravity defect cannot be obtained. The upper limit of the rate of recovery is not particularly limited.

In the column spacer of the present invention, as described above, when a compression test of compressing by 15% at 25˚C is performed repeatedly, the rate of recovery of the elastic modulus $E_5$ in the fifth compression preferably has a lower limit of 70%. When the rate of recovery is less than 70%, a force of the obtained column spacer to recover between substrates of the liquid crystal display is too low and there may be cases where a sufficient effect of inhibiting gravity defect cannot be obtained. The upper limit of the rate of recovery is not particularly limited.

In addition, the rate of recovery in deforming by compressing by 15% the column spacer in the present invention can be measured by the following method.

That is, in a compression test, the column spacer formed on the substrate is compressed at a load application rate of

10 mN/s until its height reaches 85% of its initial height $H_0$. Here, a column spacer height in applying a load of 10 mN is taken as $H_1$, a column spacer height corresponding to 85% of $H_0$ is taken as $H_2$ and a load at the moment when the column spacer height reaches $H_2$ is taken as F. Next, after this load F is held for 5 seconds to cause deformation in the column spacer at constant load, the load is removed a load application rate of 10 mN/s, and the recovery from deformation of the column spacer height by elastic recovery is measured. The column spacer height at the moment when deformation by compression reaches the maximum in this process is taken as $H_3$ and a column spacer height in applying a load of 10 mN in a process of recovering deformation of the column spacer is taken as $H_4$. The recovery rate can be determined from the following equation (4).

$$\text{Rate of recovery } R = (H_4-H_3)/(H_1-H_3)\times 100 \qquad (4)$$

It is possible to obtain a liquid crystal display element which does not produce the color irregularity due to gravity defect by designing a height of the column spacer of the present invention to be slightly higher than that of a cell gap and producing the liquid crystal display element by a publicly known method such as an ODF technology.
A liquid crystal display element formed by using the column spacers of the present invention also constitutes the present invention.

A column spacer for maintaining a gap between two glass substrates at a constant distance in a liquid crystal display element, which comprises a coefficient of linear expansion of $1\times10^{-4}$ to $5\times10^{-4}$/°C at a temperature range of 25 to 100°C, also constitutes the present invention.

The present inventors made intense investigations, and consequently found that a liquid crystal display which does not produce the color irregularity due to "gravity defect" can be formed by adapting a column spacer in such a way that a coefficient of linear expansion thereof falls within a specified range close to the coefficient of linear expansion of a liquid crystal to be used for a liquid crystal display, leading to completion of the present invention.
With respect to the cause of the gravity defect, it is thought that, conventionally, while a liquid crystal used in the liquid crystal display element had a coefficient of linear expansion of about $7\times10^{-4}$/°C at a temperature range of 25 to 100°C, a column spacer had a smaller coefficient of linear expansion of about $6\times10^{-5}$/°C at a temperature range of 25 to 100°C and there was a large difference between both coefficients of linear expansion, and therefore when a liquid crystal was heated by heat generated by a backlight and expanded, the column spacer could not expand following the expansion of the liquid crystal and consequently a substrate was lifted away from the column spacer to cause the gravity defect. On the contrary, it is thought that since by adapting a column spacer in such a way that a coefficient of linear expansion thereof falls within a specified range close to the coefficient of linear expansion of a liquid crystal, the column spacer expands following the expansion of the liquid crystal when a liquid crystal is heated by heat generated by a backlight and expanded, a substrate is not lifted away from the column spacer and the color irregularity due to the gravity defect is not produced. That is, since the column spacer of the present invention expands or contracts following the expansion or contraction of the liquid crystal associated with a change in temperature, the substrate is not lifted away from the column spacer and a gap.between the substrate and the column spacer is not formed during using a liquid crystal display element.

In the column spacer of the present invention, a coefficient of linear expansion at a temperature range of 25 to 100°C has a lower limit of $1\times10^{-4}$/°C and an upper limit of $5\times10^{-4}$/°C. When the coefficient of linear expansion is less than $1\times10^{-4}$/°C, the difference between the coefficient of linear expansion of the column spacer and the coefficient of linear expansion of the liquid crystal to be used for a liquid crystal display element becomes large, the ability of the column spacer of the present invention to follow the expansion or contraction of the liquid crystal by being heated or cooled becomes insufficient and the color irregularity due to gravity defect is produced. It is impractical as a column spacer formed by using a resin composition that the coefficient of linear expansion is more than $5\times10^{-4}$/°C. A preferable lower limit is $2\times10^{-4}$/°C and a preferable upper limit is $4\times10^{-4}$/°C.

In the present description, the above coefficient of linear expansion is a coefficient of linear expansion in the direction of the height of the column spacer, which can be determined by measuring a change in height of the column spacer in heating and cooling the column spacer within a temperature range of 25 to 100°C with an atomic force microscope. Specifically, it is possible to obtain the above coefficient of linear expansion, for example, by forming a column spacer of about 4 μm in height on a ITO surface of a glass substrate provided with an ITO of 0.7 mm in thickness using a mask having an opening 20 μm square and by measuring height differentials of a substrate surface and a column spacer top surface with an atomic force microscope while controlling a surface temperature of the substrate within a range of 25 to 100°C on a stage capable of heating and cooling. In a temperature raising process, a height of the column spacer at each temperature in the case where the surface temperature of the substrate is 25°C, 40°C, 60°C, 80°C and 100°C was measured, and further in a temperature lowering process, a height of the column spacer at each temperature in the case where the surface temperature of the substrate is 80°C, 60°C, 40°C and 25°C was measured again, and a

coefficient of linear expansion in the direction of the height of the column spacer was determined from a gradient of an approximate straight line of all measurements against temperature.

And, a temperature range of 25 to 100°C was selected as a temperature range at which a coefficient of linear expansion of the column spacer of the present invention was specified, considering a temperature range in a routine use of liquid crystal display elements, namely, a range of from room temperature to a temperature in being heated by heat from a backlight.

It is possible to obtain a liquid crystal display element, which does not produce the color irregularity due to gravity defect by designing a height of the column spacer of the present invention to be slightly higher than that of a cell gap and producing the liquid crystal display element by a publicly known method such as an ODF technology. That is, in such a liquid crystal display element, even when a liquid crystal is heated by heat generated by a backlight and expanded in using it, the column spacer can expand following the expansion of the liquid crystal, and therefore the occurrence of gravity defect can be effectively inhibited.

The liquid crystal display element formed by using the column spacers of the present invention also constitutes the present invention.

A method of producing the column spacer, having such an elastic property, of the present invention is not particularly limited, and this column spacer of the present invention can be produced, for example, by using a curable resin composition for column spacers, which comprises an alkali-soluble high polymer compound (A) having a reactive functional group, a compound (B) having a difunctional or more functional unsaturated bond and a photoreaction initiator. The curable resin composition for column spacers like this also constitutes the present invention.

The above alkali-soluble high polymer compound (A) having a reactive functional group is not particularly limited and includes, for example, alkali-soluble carboxyl group-containing high polymer compounds such as copolymer formed by copolymerizing a carboxyl group-containing monofunctional unsaturated compound with a monofunctional compound having an unsaturated double bond.

As the above carboxyl group-containing monofunctional unsaturated compound includes, for example, acrylic acid and methacrylic acid.

As the above monofunctional compound having an unsaturated double bond includes, for example, (meth)acrylic ester monomers such as methyl (meth)acrylate, ethyl (meth)acrylate, propyl (meth)acrylate, butyl (meth)acrylate, 2-ethylhexyl (meth)acrylate, hydroxyethyl (meth)acrylate, cyclohexyl (meth)acrylate, 2-methylcyclohexyl (meth)acrylate, dicyclopentanyl oxyethyl (meth)acrylate, isobornyl (meth)acrylate, dicyclopentanyl (meth)acrylate and benzyl (meth)acrylate.

And, the above alkali-soluble carboxyl group-containing high polymer compound may contain a component comprising aromatic vinyl-base monomers such as styrene, $\alpha$-methylstyrene, p-methylstyrene and p-chlorostyren; vinyl cyanide compounds such as acrylonitrile and methacrylonitrile; unsaturated dicarboxylic anhydride such as maleic anhydride; aromatic substituted maleimide such as phenylmaleimide, benzylmaleimide, naphthylmaleimide and o-chlorophenylmaleimide; and alkyl substituted maleimides such as methylmaleimide, ethylmaleimide, propylmaleimide and isopropylmaleimide.

Further, the alkali-soluble carboxyl group-containing high polymer compound may contain a monofunctional saturated compound having a hydroxyl group for the purpose of controlling the solubility in developing. The monofunctional saturated compound having a hydroxyl group is not particularly limited, and for example, a monomer having a hydroxyl group in a molecule includes, for example, 2-hydroxyethyl acrylate, 2-hydroxyethyl methacrylate, 2-hydroxypropyl acrylate, 2-hydroxypropyl methacrylate, 4-hydroxybutyl acrylate and 4-hydroxybutyl methacrylate.

In the above alkali-soluble carboxyl group-containing high polymer compound, a proportion of the component resulting from the carboxyl group-containing monofunctional unsaturated compound has a preferable lower limit of 10% by weight and a preferable upper limit of 40% by weight. When this proportion is less than 10% by weight, it is difficult to impart the solubility in alkali, and when it is more than 40% by weight, swelling in developing may be significant and it may become difficult to form patterns. A more preferable lower limit is 15% by weight and a more preferable upper limit is 30% by weight.

A method of copolymerizing the above carboxyl group-containing monofunctional unsaturated compound with the above monofunctional compound having an unsaturated double bond is not particularly limited and includes, for example, a method of polymerizing by publicly known methods, such as bulk polymerization, solution polymerization, suspension polymerization, dispersion polymerization and emulsion polymerization, using a radical polymerization initiator, and a modifier as required. Among others, the solution polymerization is suitable.

As a solvent in the case of producing the above alkali-soluble carboxyl group-containing high polymer compound by the solution polymerization, there can be used, for example, aliphatic alcohols such as methanol, ethanol, isopropanol and glycol; cellosolves such as cellosolve and butyl cellosolve; carbitols such as carbitol and butyl carbitol; esters such as cellosolve acetate, carbitol acetate and propylene glycol monomethyl ether acetate; ethers such as diethylene glycol dimethyl ether; cycloethers such as tetrahydrofuran; ketones such as cyclohexanone, methyl ethyl ketone and methyl isobutyl ketone; and polarized organic solvents such as dimethyl sulfoxide and dimethylformamide.

And, as a medium in the case of producing the above copolymer by dispersion polymerization in a non-aqueous system

such as suspension polymerization, dispersion polymerization and emulsion polymerization, there can be used, for example, liquid hydrocarbons such as benzene, toluene, hexane and cyclohexane, and other nonpolar organic solvents.

A radical polymerization initiator, used in producing the above alkali-soluble carboxyl group-containing high polymer compound, is not particularly limited and for example, publicly known radical polymerization initiators such as peroxides, an azo initiator and the like can be used. And, as the above modifier, a chain transfer agent of, for example, $\alpha$-methylstyrene dimmer, mercaptan can be used.

As the alkali-soluble high polymer compound (A) having a reactive functional group, among others, an alkali-soluble (meth)acrylic copolymer (A1) having a (meth)acrylic group and a carboxyl group on a side chain is suitable.

The present inventors made intense investigations, and consequently found that when the alkali-soluble (meth)acrylic copolymer of a specified structure, having a (meth)acrylic group and a carboxyl group on a side chain, is selected as an alkali-soluble resin in a curable resin composition generally used for resists, it is possible to obtain column spacers having the high ability to recover from a deformation by compression, flexibility and low elastic modulus. In accordance with such column spacers, it is possible to simultaneously inhibit "gravity defect" due to the expansion of the liquid crystal during heating and the "cold bubbling" due to the contraction of the liquid crystal at low temperatures.

The reason why the higher ability to recover from a deformation by compression is attained when selecting the alkali-soluble (meth)acrylic copolymer (A1) having a (meth)acrylic group and a carboxyl group on a side chain is assumed to be that the acrylic group on the side chain of the alkali-soluble resin is reacted and thereby the alkali-soluble resin is taken in into a crosslinked structure and a plastic deformation is more suppressed.

As the above alkali-soluble (meth)acrylic copolymer (A1), there is suitably used, for example, a polymer (A1-1) having a main chain comprising at least a constituent unit having an acid functional group and a constituent unit having a hydroxyl group, in which a radical polymerizable group-containing isocyanate compound is coupled to at least a part of the above acid functional group in the form of an amide bond and/or coupled to at least a part of the above hydroxyl group in the form of a urethane bond via an isocyanate group of this isocyanate compound, respectively.

In the above polymer (A1-1), by adjusting an amount of the radical polymerizable group-containing isocyanate compound to be charged so as to be 1.0 or more in terms of an equivalent ratio (NCO/OH), it becomes possible to introduce a side chain of a radical polymerizable group into the above alkali-soluble high polymer compound having a reactive functional group at a high ratio and it is possible to improve the sensitivity of the alkali-soluble high polymer compound having a reactive functional group. And, since the content of the constituent unit having an acid functional group can be adjusted to appropriate proportions, solubility in alkali (a developing property) can be controlled freely.

In the above polymer (A1-1), it is preferred to adjust an equivalent ratio (NCO/OH) of an isocyanate group to be 1.0 or more and also to adjust an amount of the constituent unit having a hydroxyl group to be charged so that the content of the constituent unit having a hydroxyl group is 14 mole% or more. By adjusting the above equivalence ratio (NCO/OH) of an isocyanate group to be 1.0 or more a ratio of introducing the isocyanate group is enhanced and simultaneously adjusting the amount of the constituent unit having a hydroxyl group to be charged so as to be 14 mole% or more a portion reacting with the isocyanate group is increased, it becomes possible to introduce a side chain of a radical polymerizable group into the alkali-soluble high polymer compound (A) having a reactive functional group in high amounts and particularly high sensitivity can be attained.

The amount of the above radical polymerizable group-containing isocyanate compound to be charged has a preferable upper limit of 2.0 in terms of an equivalent ratio (NCO/OH) of an isocyanate group. When the above equivalent ratio (NCO/OH) is more than 2.0, an unreacted radical polymerizable group-containing isocyanate compound remains in the alkali-soluble high polymer compound having a reactive functional group in high amounts, and this causes the physical properties of the above alkali-soluble high polymer compound (A) having a reactive functional group to deteriorate.

The above constituent unit having an acid functional group is a component contributing to an alkaline development property and its content is not particularly limited and appropriately adjusted according to a degree of the solubility in alkali required of the alkali-soluble high polymer compound (A) having a reactive functional group. As a monomer to be used for introducing a constituent unit having the above acid functional group into a main chain of a polymer, includes a compound having a double bond-containing group and an acid functional group.

The above acid functional group is not particularly limited and is usually a carboxyl group, but it may be one other than the carboxyl group as long as it is a component which can contribute to an alkaline development property.

Among others, as the above constituent unit having an acid functional group, a constituent unit expressed by the following chemical formula (5) is preferred.

[Chem. 1]

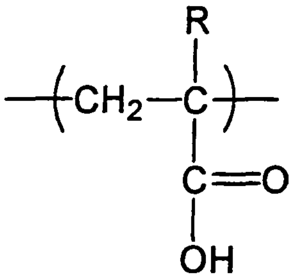

(5)

R contained in the above chemical formula (5) and other formulas described later represents hydrogen or an alkyl group having 1 to 5 carbon atoms.
The above alkyl group is not particularly limited and includes, for example, methyl group, ethyl group, n-propyl group, iso-propyl group, n-butyl group, iso-butyl group, sec-butyl group, tert-butyl group and n-pentyl group.
A monomer to be used for introducing the constituent unit of the above chemical formula (5) is not particularly limited and includes, for example, acrylic acid, methacrylic acid, 2-carboxy-1-butene, 2-carboxy-1-pentene, 2-carboxy-1-hexene and 2-carboxy-1-heptene.
The above constituent unit having a hydroxyl group is not particularly limited but a constituent unit expressed by the following chemical formula (6) is preferred.
[Chem. 2]

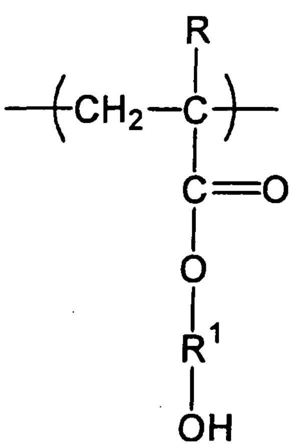

(6)

In the above chemical formula (6), R is identical to R in the above chemical formula (5) and $R^1$ represents an alkylene group having 2 to 4 carbon atoms. As the above $R^1$, there are given, for example, ethylene group, propylene group and butylene group.
And, a monomer to be used for introducing the constituent unit of the above chemical formula (6) is not particularly limited and includes, for example, 2-hydroxyethyl acrylate, 2-hydroxyethyl methacrylate, 2-hydroxypropyl acrylate, 2-hydroxypropyl methacrylate, 4-hydroxybutyl acrylate and 4-hydroxybutyl methacrylate.
The main chain of the above polymer (A1-1) contains a constituent unit, having an acid functional group, of the chemical formula (5) or the like and a constituent unit, having of a hydroxyl group, of the chemical formula (6) or the like as an essential copolymerization component, but it may contain other copolymerization components. For example, the main chain of the above polymer may contain a constituent unit having an aromatic carbon ring and/or a constituent unit having an ester group.
A constituent unit having the above aromatic carbon ring is not particularly limited but includes, for example, a constituent unit expressed by the following chemical formula (7) is preferred.

[Chem. 3]

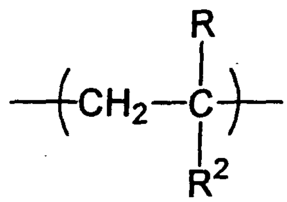

(7)

In the above chemical formula (7), R is identical to R in the above chemical formula (5) and $R^2$ represents an aromatic carbon ring. As such $R^2$, there are given, for example, phenyl group and naphthyl group.

A monomer to be used for introducing the constituent unit of the above chemical formula (7) is not particularly limited and includes, for example, styrene, α-methylstyrene and the like, and the aromatic ring of this monomer may have a substituent of halogen atoms such as chlorine, bromine and the like, alkyl groups such as methyl group, ethyl group and the like, amino groups such as amino group, dialkylamino group and the like, cyano group, carboxyl group, sulfonate group or phosphate group.

A monomer to be used for introducing a constituent unit having the above ester group into a main chain of a polymer is not particularly limited and includes, for example, a compound having a double bond-containing group and an ester group and a constituent unit expressed by the following chemical formula (8) is preferred.

[Chem. 4]

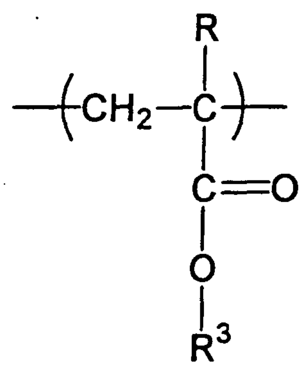

(8)

In the above chemical formula (8), R is identical to R in the above chemical formula (5) and $R^3$ represents an alkyl group or an aralkyl group. As such $R^3$, there are given, for example, an alkyl group having 1 to 12 carbon atoms and an aralkyl group such as a benzyl group and a phenylethyl group.

A monomer to be used for introducing the constituent unit of the above chemical formula (8) is not particularly limited and includes, for example, (meth)acrylates such as methyl (meth)acrylate, ethyl (meth)acrylate, butyl (meth) acrylate, 2-ethylhexyl (meth)acrylate, phenyl (meth)acrylate, cyclohexyl (meth)acrylate, dicyclopentanyl (meth)acrylate, dicyclopentanyl oxyethyl (meth)acrylate, isobornyl (meth)acrylate, benzyl (meth)acrylate and phenylethyl (meth)acrylate.

In the main chain composed of the above respective constituent units, the radical polymerizable group-containing isocyanate compound is coupled to at least a part of the above acid functional group in the form of an amide bond and/or coupled to at least a part of the above hydroxyl group in the form of a urethane bond via an isocyanate group of the isocyanate compound, respectively, and the side chain of the radical polymerizable group are formed.

The above radical polymerizable group-containing isocyanate compound is not particularly limited and includes, for example, (meth)acryloyloxyalkyl isocyanate expressed by the following chemical formula (9) is preferred.

[Chem. 5]

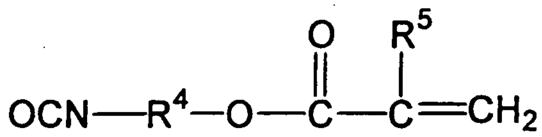

(9)

In the above chemical formula (9), $R^4$ represents an alkylene group and $R^5$ represents hydrogen or a methyl group. And, among (meth)acryloyloxyalkyl isocyanates of the chemical formula (9), a compound formed by coupling a (meth)acryloyl group to an isocyanate group (-NCO) via an alkylene group having 2 to 6 carbon atoms is preferred. Specifically, there are given 2-acryloyloxyethyl isocyanate, 2-methacryloyloxyethyl isocyanate and the like. And, as a commercially available product of the above 2-methacryloyloxyethyl isocyanate, there is given, for example, "karenzMOI" produced by SHOWA DENKO K.K.

The above polymer comprising such the constituent units can be obtained by producing a polymer (a raw material polymer) having a main chain comprising at least a constituent unit, having an acid functional group, of the chemical formula (5) or the like and a constituent unit, having a hydroxyl group, of the chemical formula (6) or the like, and further containing a constituent unit, having an aromatic carbon ring, of the chemical formula (7) or the like, a constituent unit, having an ester group, of the chemical formula (8) or the like or other constituent units as required, and then by reacting this polymer with a radical polymerizable group-containing isocyanate compound.

As a solvent for polymerization used for producing the above raw material polymer, a solvent not having active hydrogen such as hydroxyl group, amino group, etc. is preferred, and for example, ethers such as tetrahydrofuran; glycol ethers such as diethylene glycol dimethyl ether, diethylene glycol diethyl ether and diethylene glycol methylethyl ether, cellosolve esters such as methyl cellosolve acetate, propylene glycol monomethyl ether acetate and 3-methoxybutyl acetate are given, and aromatic hydrocarbons, ketones and esters can also be used.

As a polymerization initiator used for producing the above raw material polymers, publicly known radical polymerization initiators can be used and this initiator includes, specifically, nitrile-based azo compounds (nitrile-based azo initiators) such as 2,2'-azobisisobutyronitrile, 2,2'-azobis(2,4-dimethyl)valeronitrile and 2,2'-azobis(4-methoxy-2,4-dimethylvaleronitrile); non-nitrile-based azo compounds (non-nitrile-based azo initiators) such as dimethyl2,2'-azobis (2-methyl propionate) and 2,2'-azobis(2,4,4-trimethylpentane); organic peroxides (peroxide polymerization initiator) such as t-hexyl peroxy pivalate, tert-butyl peroxy pivalate, 3,5,5-trimethyl hexanoyl peroxide, octanoyl peroxide, lauroyl peroxide, stearoyl peroxide, 1,1,3,3-tetramethylbutyl peroxy2-ethyl hexanoate, succinic peroxide, 2,5-dimethyl-2,5-di(2-ethyl hexanoyl peroxy) hexane, 1-cyclohexyl-1-methylethyl peroxy2-ethyl hexanoate, t-hexyl peroxy2-ethyl hexanoate, 4-metyl benzoyl peroxide, benzoyl peroxide and 1,1'-bis-(tert-butylperoxy)cyclohexane; and hydrogen peroxide. When a peroxide is used as the above radical polymerization initiator, it may be used in combination with a reducing agent as a redox initiator.

In the production of the above raw material polymers, a modifier may be used in order to adjust a weight average molecular weight. The above modifier includes, for example, halogenated hydrocarbons such as chloroform, carbon tetrabromide, etc.; mercaptans such as n-hexyl mercaptan, n-octyl mercaptan, n-dodecyl mercaptan, tert-dodecyl mercaptan, thioglycol, etc.; xanthogens such as dimethyl xanthogen disulfide, diisopropyl xanthogen disulfide, etc.; terpinolene and $\alpha$-methylstyrene dimer.

The above raw material polymers may be any of a random copolymer and a blocked copolymer.
When the random copolymer is produced, it can be polymerized, for example, by adding dropwise a compound composition consisting of monomers expressed by the above chemical formulas (5) to (8) and a catalyst into a polymerization vessel containing a solvent at a temperature of 80 to 110°C over 2 to 5 hours and aging it.

A weight average molecular weight on the polystyrene equivalent basis (hereinafter, referred to as only a "weight average molecular weight" or "Mw") of the raw material polymer having the constituent units of the above chemical formulas (5) to (8) has a preferable lower limit of 10000 and a preferable upper limit of 1000000, an acid vale of the raw material polymer has a preferable lower limit of 5 mgKOH/g and a preferable upper limit of 400 mgKOH/g and an hydroxyl group value has a preferable lower limit of 5 mgKOH/g and a preferable upper limit of 400 mgKOH/g.

The reaction of the above raw material polymer and the radical polymerizable group-containing isocyanate compound can be performed by charging all of the radical polymerizable group-containing isocyanate compound at a time into a solution of the raw material polymer and then continuing the reaction for a given time, or by adding dropwise the radical polymerizable group-containing isocyanate compound little by little in the presence of a small amount of catalyst.
The above catalyst is not particularly limited and includes, for example, dibutyltin laurate and the like, and inhibitors such as p-methoxyphenol, hydroquinone, naphthylamine, tert-butylcatechol and 2,3-di-tert-butyl p-cresol are used as required.

The above radical polymerizable group-containing isocyanate compound is coupled to the acid functional group in the above raw material polymer in the form of an amide bond via isocyanate. For example, a part of a constituent unit of the above chemical formula (5) is coupled by an amide bond with carbon dioxide released to form a constituent unit expressed by the following chemical formula (10).
On the other hand, the above radical polymerizable group-containing isocyanate compound is coupled to the hydroxyl group in the above raw material polymer in the form of a urethane bond via isocyanate. For example, a constituent unit of the above chemical formula (6) is coupled by a urethane bond by an addition reaction to form a constituent unit expressed by the following chemical formula (11).
[Chem. 6]

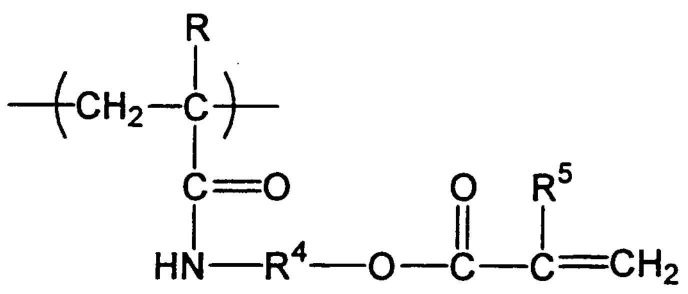

(10)

[Chem. 7]

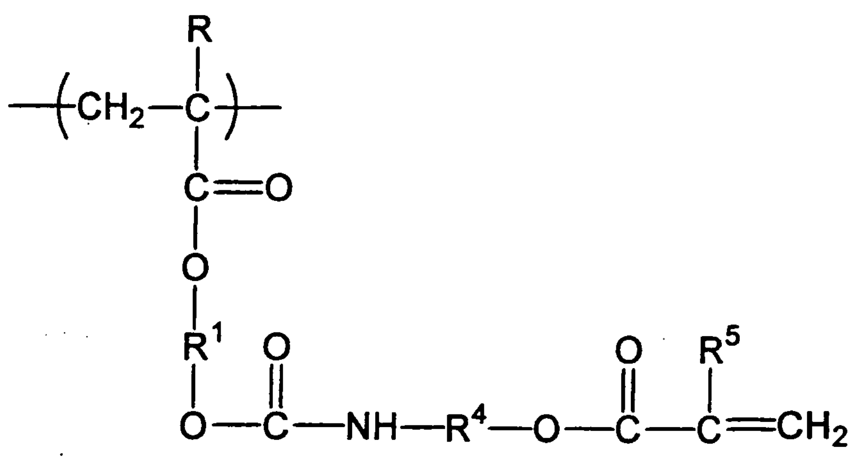

(11)

The polymer thus obtained has a molecular structure in which the constituent unit, having an acid functional group, of the chemical formula (5) or the like, the constituent unit, having of a hydroxyl group, of the chemical formula (6) or the like, the constituent unit of the chemical formula (10) or the like, formed by introducing a radical polymerizable group into a constituent unit having an acid functional group, and the constituent unit of the chemical formula (11) or the like, formed by introducing a radical polymerizable group into a constituent unit, having of a hydroxyl group, of the chemical formula (6) are coupled in arbitrary order.
As the above alkali-soluble (meth)acrylic copolymer (A1), there is also suitably used a copolymer (A1-2) comprising each structural unit expressed by the following formulas (1a), (1b), (1c), (1d) and (1e).
[Chem. 8]

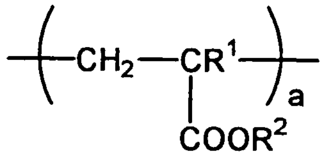

(1a)

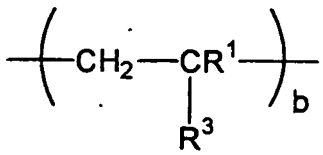

(1b)

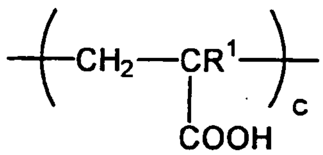

(1c)

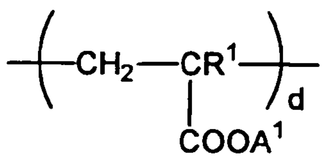

(1d)

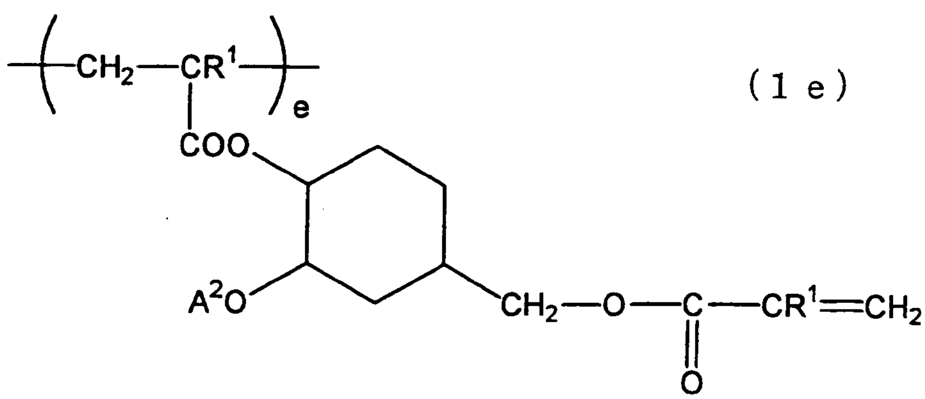

(1e)

$A^1$ and $A^2$ in the formulas (1a), (1b), (1c), (1d) and (1e) represent hydrogen or a group expressed by the following formulas (2a), (2b), (2c) or (2d), and when either of $A^1$ or $A^2$ is hydrogen, the other is any one of groups expressed by the following formulas (2a), (2b), (2c) or (2d). $R^1$ represents hydrogen and/or methyl group, $R^2$ represents an alkyl group, phenyl group, a phenyl group containing an alkyl group or an alkoxy group, a hydroxyalkyl group or alicyclic hydrocarbons, $R^3$ represents a nitrile group or phenyl group and $R^4$ represents an alkyl group, a hydroxyalkyl

group or radical polymerizable group-containing aliphatic hydrocarbons. And, a, b, c, d and e represent mole ratios (%) of the respective components, and when a+b+c+d+e = 100, a, b and d are 0 to 90, c is 5 to 50 and e is 5 to 60.

[Chem. 9]

$A^1$, $A^2$ : 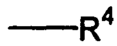 (2a)

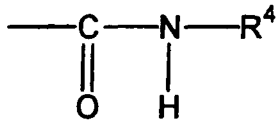 (2b)

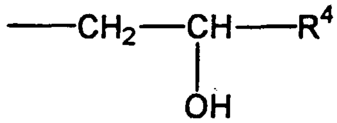 (2c)

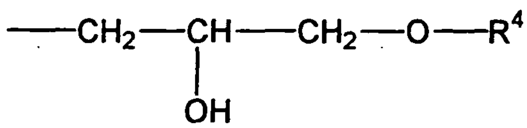 (2d)

By containing such a copolymer (A1-2), column spacers formed by curing the curable resin composition for column spacers of the present invention can realize the compatibility between the high ability to recover from a deformation by compression and the flexible and low elastic property. And, the above copolymer (A-1-2) is superior in compatibility in a composition because its segment has a low polarity. Thereby, a malfunction such as uneven development does not occur in developing in producing column spacers.

Particularly, $A^1$ and $A^2$ in the above copolymer (A1-2) is preferably expressed by the above formula (2b) for the reason that a structure of the formula (2b) can provide flexibility while maintaining a high crosslinking property since it has a urethane bond having high flexibility, in its structure, and the compatibility in a composition is excellent since the urethane bond has moderate polarity.

And, $A^1$ and/or $A^2$ in the above copolymer (A1-2) is preferably expressed by the above formula (2b) and $R^4$ in the above formula (2b) is preferably radical polymerizable group-containing aliphatic hydrocarbons for the reason that when the radical polymerizable group is contained in a structural unit coupled by a urethane bond, it is possible to simultaneously provide higher crosslinking and flexibility, and the compatibility is further enhanced since the radical polymerizable group is photo-crosslinked with other components.

And, $A^1$ and $A^2$ in the above copolymer (A1-2) is preferably expressed by the above formula (2c) or (2d) for the reason that a structure of the formula (2c) or (2d) is superior in an alkaline development property and adhesion to a base material by having a hydroxyl group, and it can develop the compatibility with other components by having both a hydroxyl group having a high polarity and $R^4$ having a low polarity.

A weight average molecular weight of the above copolymer (A1-2) is not particularly limited but has a preferable lower limit of 3000 and a preferable upper limit of 100000. When the weight average molecular weight is less than 3000, the developing property of the column spacers may be deteriorated, and when it is more than 100000, the resolution may be reduced. A more preferable lower limit is 5000 and a more preferable upper limit is 50000.

A method of producing the above copolymer (A1-2) is not particularly limited and includes, for example, a method in which a (meth)acrylic copolymer having a carboxyl group on a side chain is polymerized with an alicyclic epoxy group-containing unsaturated compound by ring-opening and addition to modify a part of the carboxyl group and further a part of a hydroxyl group produced by this modification and/or a remaining carboxyl group with an isocyanate compound, an epoxy compound, a lactone compound or an alcohol compound.

And, specifically, CYCLOMER P (produced by DAICEL CHEMICAL INDUSTRIES, LTD.), for example, is commercially available and further by reacting a part of a hydroxyl group and a carboxyl group contained in CYCLOMER P with an isocyanate compound, an epoxy compound, a lactone compound or an alcohol compound, the above copolymer (A1-2) can also be obtained.

A method of producing the above (meth)acrylic copolymer having a carboxyl group on a side chain is not particularly limited and includes, for example, a method of copolymerizing a carboxyl group-containing monofunctional unsaturated compound with a (meth)acrylate-based monomer by publicly known methods, such as bulk polymerization, solution polymerization, suspension polymerization, dispersion polymerization and emulsion polymerization, using a radical polymerization initiator, and a modifier as required.

The above alicyclic epoxy group-containing unsaturated compound is not particularly limited, but for example, 3,4-epoxycyclohexyl (meth)acrylate is preferably used.

The above isocyanate compound is not particularly limited but, for example, alkyl isocyanate having 2 to 18 carbon atoms and polymerizable group-containing isocyanate are suitably used.

In alkyl isocyanate having 19 or more carbon atoms, since its polarity is reduced, the compatibility with a (meth)acrylic copolymer having a carboxyl group on a side chain may not be attained and the reaction may not proceed smoothly.

When the above polymerizable group-containing isocyanate compound is employed, further improvements in various characteristics such as an increase in the sensitivity in photo-curing are realized, heat resistance, chemical resistance and a tack-free property.

The above polymerizable group-containing isocyanate compound is not particularly limited, but for example, a compound formed by coupling a (meth)acryloyl group to an isocyanate group via an alkylene group having 2 to 6 carbon atoms is preferably used. Specifically, for example, 2-acryloyloxyethyl isocyanate, 2-methacryloylethyl isocyanate and 2-acryloylethyl isocyanate are given, and 2-methacryloylethyl isocyanate and 2-acryloylethyl isocyanate are commercially available as karenzMOI and karenzAOI (produced by SHOWA DENKO K.K).

A method of reacting the (meth)acrylic copolymer having a hydroxyl group and a carboxyl group on a side chain, which has been produced by the above modification, with the above isocyanate compound is not particularly limited and includes a method of adding dropwise the above isocyanate compound to or mixing the above isocyanate compound into a solution of the (meth)acrylic copolymer having a hydroxyl group and a carboxyl group on a side chain, which has been produced by the above modification, in the presence of a small amount of catalyst.

The catalyst used in this case is not particularly limited and includes, for example, Di-n-butyltin dilaurate, and the like.

And, inhibitors such as p-methoxyphenol, hydroquinone, naphthylamine, tert-butylcatechol and 2,3-di-tert-butyl-p-cresol may be used as required.

And, for the purpose of inhibiting thickening, treatment with alcohol such as methanol, ethanol, propanol, butanol, pentanol, hexanol, heptanol, octanol and decanol may be done.

When the (meth)acrylic copolymer having a hydroxyl group and a carboxyl group on a side chain, produced by the above modification, is reacted with the isocyanate compound according to the above production method, the structural unit shown in a formula (2b) is formed.

The above epoxy resin compound is not particularly limited and includes, for example, alkyl epoxy compounds having 2 to 18 carbon atoms, alkoxy epoxy compounds having 2 to 18 carbon atoms and polymerizable group-containing epoxy compounds. When the epoxy compound has 19 or more carbon atoms, since its polarity is reduced, the compatibility with a (meth)acrylic copolymer having a carboxyl group on a side chain may not be attained and the reaction may not proceed smoothly.

When the above polymerizable group-containing epoxy compound is employed, further improvements in various characteristics such as an increase in the sensitivity in photo-curing are realized, heat resistance, chemical resistance and a tack-free property.

The above polymerizable group-containing epoxy compound is not particularly limited, but for example, a compound formed by coupling a (meth)acryloyl group to an epoxy group via an alkylene group having 2 to 6 carbon atoms is preferably used. Specifically, for example, there is given glycidyl (meth)acrylate.

A method of reacting the (meth)acrylic copolymer having a hydroxyl group and a carboxyl group on a side chain, which has been produced by the above modification, with the above epoxy compound is not particularly limited and includes a method of adding dropwise the above epoxy compound to or mixing the above epoxy compound into a solution of the (meth)acrylic copolymer having a hydroxyl group and a carboxyl group on a side chain, which has been produced by the above modification, in the presence of a small amount of catalyst.

The catalyst used in this case is not particularly limited and includes, for example, triethylamine, tripropylamine, tetramethylethylenediamine, dimethyllaurylamine, triethylbenzylammonium chloride, trimethylcetylammonium bromide, tetrabutylammonium bromide, trimethylbutylphosphonium bromide and tetrabutylphosphonium bromide. And, inhibitors such as p-methoxyphenol, hydroquinone, naphthylamine, tert-butylcatechol and 2,3-di-tert-butyl-p-cresol may be used as required.

When the above (meth)acrylic copolymer having a hydroxyl group and a carboxyl group on a side chain, which

has been produced by the above modification, is reacted with an epoxy compound according to the above production method, the structural units expressed by the formulas (2c) and (2d) are formed.

When the (meth)acrylic copolymer having a hydroxyl group and a carboxyl group on a side chain is reacted with the above isocyanate compound or the above epoxy compound, a lactone compound or an alcohol compound, a proportion equivalent to 0 to 100 mole% of the hydroxyl group contained in the (meth)acrylic copolymer can be reacted, but a preferable lower limit of this proportion is 10 mole%. When the proportion is less than 10 mole%, much hydroxyl group remains after the reaction and the polarity of the resin becomes high, and therefore adequate compatibility may not be obtained particularly when a substance containing a trifunctional or more functional caprolactone modified (meth) acrylate compound is used as a crosslinking monomer.

And, when the (meth)acrylic copolymer having a hydroxyl group and a carboxyl group on a side chain is reacted with the above isocyanate compound or the above epoxy compound, a lactone compound or an alcohol compound, a proportion equivalent to 0 to 90 mole% of the carboxyl group contained in the (meth)acrylic copolymer can be reacted. When this proportion is more than 90 mole%, the solubility in alkali may be impaired and the developing property may be deteriorated since an amount of remaining carboxyl group is too small.

Alphabetical letters a, b, c, d and e in the above formulas (1a), (1b), (1c), (1d) and (1e) represent a mole ratio (%) of each component, and when a+b+c+d+e = 100, the lower limits of a, b and d are 0% and the upper limits thereof are 90%. The lower limit of c is 5% and the upper limit thereof is 50%. And, the lower limit of e is 5% and the upper limit thereof is 60%. The lower limit of c is 5% and the upper limit thereof is 50%, but when c is less than 5%, that is, a mole ratio of a carboxyl group-containing structural unit is less than 5%, it is difficult to impart the solubility in alkali, and when c is more than 50%, swelling in developing is significant and it becomes difficult to form patterns. And, the preferable lower limit of e is 5% and the preferable upper limit thereof is 60%, but when it is less than 5%, the incorporation of the alkali-soluble resin into a crosslinked structure becomes insufficient and therefore an effect of improving the rate of recovery from a deformation by compression cannot be attained, and when it is more than 60%, a crosslinking density of the crosslinked structure becomes high and a flexible property is impaired.

As the above alkali-soluble high polymer compound (A) having a reactive functional group, there are suitably used a copolymer (A2) containing unsaturated carboxylic acid and/or unsaturated carboxylic anhydride, and a blocked isocyanate group-containing unsaturated compound. A column spacer produced by using the curable resin composition for column spacers of the present invention containing the copolymer (A2) having such a structure becomes superior in the elasticity and the rate of recovery from a deformation by compression, and the produced display element does not produce the gravity defect. The reason for this is not clear but is assumed to be as follows.

That is, the reason for this is assumed to be that the blocked isocyanate group and the carboxyl group (and the hydroxyl group) in the alkali-soluble high polymer compound are reacted at a post bake step in producing column spacers and thereby a plasticizer-like behavior of the alkali-soluble high polymer compound is suppressed and a plastic deformation in a deformation by compression of the produced column spacer is inhibited.

The unsaturated carboxylic acid and/or unsaturated carboxylic anhydride in the above copolymer (A2) is not particularly limited and includes, for example, monocarboxylic acid such as acrylic acid, methacrylic acid and crotonic acid; dicarboxylic acid such as maleic acid, fumaric acid, citraconic acid, mesaconic acid and itaconic acid; methacrylic acid derivatives having a carboxyl group and a ester bond such as 2-succinyloxyethyl methacrylate, 2-maleoyloxyethyl methacrylate and 2-hexahydrophthaloyloxyethyl methacrylate; and anhydride thereof. These compounds may be used alone or in combination of two or more species. Among others, there are suitably used acrylic acid, methacrylic acid and 2-hexahydrophthaloyloxyethyl methacrylate.

The composition ratio of the above unsaturated carboxylic acid and/or unsaturated carboxylic anhydride in the above copolymer (A2) is not particularly limited but has a preferable lower limit of 10% by weight and a preferable upper limit of 40% by weight. When the composition ratio is less than 10% by weight, it becomes difficult to impart the solubility in alkali to the curable resin composition for column spacers of the present invention. When it is more than 40% by weight, swelling during developing in producing column spacers is significant and it may become difficult to form patterns of the column spacers. A more preferable lower limit is 15% by weight and a more preferable upper limit is 30% by weight.

The blocked isocyanate group-containing unsaturated compound in the above copolymer (A2) is not particularly limited and includes, for example, substances obtained by blocking isocyanates with an active methylene-based, oxime-based, lactam-based or alcohol-based blocking agent compound. Specifically, there is given, for example, 2-(o-[1'-methylpropylideneamino]carboxyamino)ethyl (meth)acrylate. As a commercially available product of this blocked isocyanate group-containing unsaturated compound, there is given "karenzMOI-BM" produced by SHOWA DENKO K.K.

The composition ratio of the above blocked isocyanate group-containing unsaturated compound in the above copolymer (A2) is not particularly limited but has a preferable lower limit of 2% by weight and a preferable upper limit of 90% by weight. When the composition ratio is less than 2% by weight, crosslinking of the alkali-soluble high polymer compound becomes insufficient and therefore a plastic deformation of the column spacer is large and the gravity defect tend to occur in the produced liquid crystal display element. When it is more than 90% by weight, it becomes difficult to impart the solubility in alkali since the content of the unsaturated carboxylic acid and/or unsaturated carboxylic anhydride

is relatively reduced. A more preferable lower limit is 5% by weight and a more preferable upper limit is 85% by weight.
Further, the above copolymer (A2) is preferably a copolymer containing a hydroxyl group-containing unsaturated compound. By introducing the hydroxyl group, an efficiency of a crosslinking reaction with a blocked isocyanate group is enhanced and the solubility in developing with alkali can be adjusted.
As the hydroxyl group-containing unsaturated compound in the above copolymer (A2), there are given, for example, hydroxyalkyl esters (meth)acrylate such as 2-hydroxyethyl (meth)acrylate and 2-hydroxypropyl (meth)acrylate.
The composition ratio of the above hydroxyl group-containing unsaturated compound in the above copolymer (A2) is not particularly limited but preferably has an upper limit of 40% by weight. When this ratio is more than 40% by weight, the swelling of a pattern in alkaline development is significant, and therefore the solution of the pattern is deteriorated and defects such as washout of the pattern becomes apt to arise. A more preferable upper limit is 30% by weight.
Further, the above copolymer (A2) may be a copolymer in which the above unsaturated carboxylic acid and/or unsaturated carboxylic anhydride, the above blocked isocyanate group-containing unsaturated compound and a structural unit derived from a polymerizable unsaturated compound other than a hydroxyl group-containing unsaturated compound are contained.
As the above polymerizable unsaturated compound, there are given (meth)acrylic alkyl esters such as methyl (meth) acrylate, ethyl (meth)acrylate, propyl (meth)acrylate, butyl (meth)acrylate, 2-ethylhexyl (meth)acrylate and hydroxyethyl (meth)acrylate; (meth)acrylic cycloalkyl esters such as cyclohexyl (meth)acrylate, 2-methylcyclohexyl (meth)acrylate, dicyclopentanyl (meth)acrylate and isobornyl (meth)acrylate; (meth)acrylic aryl esters such as phenyl (meth)acrylate and benzyl (meth)acrylate; aromatic vinyl-base monomers such as styrene, $\alpha$-methylstyrene, p-methylstyrene and p-chlorostyren; vinyl cyanide compounds such as acrylonitrile and methacrylonitrile; aromatic substituted maleimide such as phenylmaleimide, benzylmaleimide, naphthylmaleimide and o-chlorophenylmaleimide; and alkyl substituted maleimides such as methylmaleimide, ethylmaleimide, propylmaleimide and isopropylmaleimide.
A weight average molecular weight of the above copolymer (A2) is not particularly limited but has a preferable lower limit of 3000 and a preferable upper limit of 100000. When the weight average molecular weight is less than 3000, the developing property in producing the column spacers using the curable resin composition for column spacers of the present invention may be deteriorated, and when it is more than 100000, the resolution in producing the column spacers using the curable resin composition for column spacers of the present invention may be reduced. A more preferable lower limit is 5000 and a more preferable upper limit is 50000.
A method of producing the above copolymer (A2) is not particularly limited and includes, for example, a method of polymerizing by publicly known methods such as bulk polymerization, solution polymerization, suspension polymerization, dispersion polymerization and emulsion polymerization, using a radical polymerization initiator, and a modifier as required. Among others, the solution polymerization is suitable.
As a solvent used in the case of producing the above copolymer (A2) by the solution polymerization method, there can be used, for example, aliphatic alcohols such as methanol, ethanol, isopropanol and glycol; cellosolves such as cellosolve and butyl cellosolve; carbitols such as carbitol and butyl carbitol; esters such as cellosolve acetate, carbitol acetate and propylene glycol monomethyl ether acetate; ethers such as diethylene glycol dimethyl ether; cycloether such as tetrahydrofuran; ketones such as cyclohexanone, methyl ethyl ketone and methyl isobutyl ketone; and polarized organic solvents such as dimethyl sulfoxide and dimethylformamide.
And, as a medium used in the case of producing the above copolymer (A2) by dispersion polymerization in a non-aqueous system such as suspension polymerization, dispersion polymerization and emulsion polymerization, there can be used, for example, liquid hydrocarbons such as benzene, toluene, hexane and cyclohexane, and other nonpolar organic solvents.
A radical polymerization initiator, used in producing the above copolymer (A2), is not particularly limited and for example, publicly known radical polymerization initiators such as peroxides, an azo initiator and the like can be used. An amount of the above radical polymerization initiator to be used has, for example, a preferable lower limit of 0.001 parts by weight and a preferable upper limit of 5.0 parts by weight with respect to 100 parts by weight of the total monomers of the above copolymer (A2), and a more preferable lower limit of 0.5 parts by weight and a more preferable upper limit of 3.0 parts by weight.
As the above modifier, a chain transfer agent of, for example, a-methylstyrene dimer or mercaptan can be used. Among others, long chain alkyl mercaptan having 8 or more carbon atoms is preferred in point of less odor or coloring.
As the above alkali-soluble high polymer compound (A) having a reactive functional group, there is also suitably used an alkali-soluble (meth)acrylic copolymer (A3) having an epoxy group on a side chain. Such the copolymer (A3) includes, for example, a copolymer (A3-1) of unsaturated carboxylic acid and/or unsaturated carboxylic anhydride, an epoxy group-containing unsaturated compound and other unsaturated compounds other than these unsaturated compounds.
As the above unsaturated carboxylic acid and/or unsaturated carboxylic anhydride is not particularly limited

and includes, for example, the same compounds as that used in the copolymer (A2).
A proportion of the above unsaturated carboxylic acid and/or unsaturated carboxylic anhydride, which the above copolymer (A3-1) constitutes, is not particularly limited but has a preferable lower limit of 5% by weight and a preferable upper limit of 40% by weight. When this proportion is less than 5% by weight, the copolymer (A3-1) becomes hard to dissolve in an alkali aqueous solution, and when it is more than 40% by weight, the solubility in the alkali aqueous solution tends to become too high. A more preferable lower limit is 10% by weight and a more preferable upper limit is 30% by weight.
As the above epoxy group-containing unsaturated compound is not particularly limited and includes, for example, glycidyl acrylate, glycidyl methacrylate, glycidyl $\alpha$-ethylacrylate, glycidyl $\alpha$-n-propylacrylate, glycidyl $\alpha$-n-butylacrylate, 3,4-epoxybutyl acrylate, 3,4-epoxybutyl methacrylate, 6,7-epoxyheptyl acrylate, 6,7-epoxyheptyl methacrylate, 6,7-epoxyheptyl $\alpha$-ethylacrylate, o-vinylbenzyl glycidyl ether, m-vinylbenzyl glycidyl ether and p-vinylbenzyl glycidyl ether. Among others, glycidyl methacrylate, 6,7-epoxyheptyl methacrylate, o-vinylbenzyl glycidyl ether, m-vinylbenzyl glycidyl ether and p-vinylbenzyl glycidyl ether are preferably employed from the viewpoint of the reactivity of copolymerization and enhancing the strength of column spacers to be obtained. These compounds may be used alone or in combination of two or more species.
A proportion of the epoxy group-containing unsaturated compound, which the above copolymer (A3-1) constitutes, is not particularly limited but has a preferable lower limit of 10% by weight and a preferable upper limit of 70% by weight. When this proportion is less than 10% by weight, the strength of the obtained column spacers tends to deteriorate, and when it is more than 70% by weight, the storage stability of the copolymer (A3-1) tends to deteriorate. A more preferable lower limit is 20% by weight and a more preferable upper limit is 60% by weight.
Other unsaturated compounds in the above copolymer (A3-1) is not particularly limited and includes, for example, methacrylic alkyl esters such as methyl methacrylate, ethyl methacrylate, n-butyl methacrylate, sec-butyl methacrylate and t-butyl methacrylate; acrylic alkyl esters such as methyl acrylate and isopropyl acrylate; methacrylic cycloalkyl esters such as cyclohexyl methacrylate, 2-methylcyclohexyl methacrylate, dicyclopentanyl methacrylate, dicyclopentenyl oxyethyl methacrylate and isobornyl methacrylate; acrylic cycloalkyl esters such as cyclohexyl acrylate, 2-methylcyclohexyl acrylate, dicyclopentanyl acrylate, dicyclopenta oxyethyl acrylate and isobornyl acrylate; methacrylic aryl esters such as phenyl methacrylate and benzyl methacrylate; acrylic aryl esters such as phenyl acrylate and benzyl acrylate; dicarboxylic diesters such as diethyl maleate, diethyl fumarate and diethyl itaconate; hydroxyalkyl esters such as 2-hydroxyethyl methacrylate and 2-hydroxypropyl methacrylate; styrene, $\alpha$-methylstyrene, m-methylstyrene, p-methylstyrene, vinyl toluene, p-methoxystyrene, acrylonitrile, methacrylonitrile, vinyl chloride, vinylidene chloride, acrylamide, methacrylamide, vinyl acetate, 1,3-butadiene, isoprene and 2,3-dimethyl-1,3-butadiene. Among others, styrene, t-butyl methacrylate, dicyclopentanyl methacrylate, p-methoxystyrene, 2-methylcyclohexyl acrylate and 1,3-butadiene are suitable from the viewpoint of the reactivity of copolymerization and the solubility in an alkali aqueous solution. These may be used alone or in combination of two or more species.
A proportion of the above other unsaturated compounds, which the above copolymer (A3-1) constitutes, is not particularly limited but has a preferable lower limit of 10% by weight and a preferable upper limit of 70% by weight. When this proportion is less than 10% by weight, the storage stability of the copolymer (A3-1) tends to deteriorate, and when it is more than 70% by weight, the copolymer (A3-1) becomes hard to dissolve in the alkali aqueous solution. A more preferable lower limit is 20% by weight and a more preferable upper limit is 50% by weight.
The above copolymer (A3-1) can be obtained by copolymerizing the above unsaturated carboxylic acid and/or unsaturated carboxylic anhydride, the epoxy group-containing unsaturated compound and the other unsaturated compounds other than these unsaturated compounds together with a publicly known radical polymerization initiator in a solvent.
The above compound (B) having a difunctional or more functional unsaturated bond is not particularly limited and includes, for example, a difunctional or more functional (meth)acrylate compound.
Further, in the present description, a (meth)acrylate compound refers to an acrylate compound and a methacrylate compound.
The above difunctional or more functional (meth)acrylate compound is not particularly limited and includes, for example, difunctional monomers such as diethylene glycol di(meth)acrylate, triethylene glycol di(meth)acrylate, tetraethylene glycol di(meth)acrylate, neopentyl glycol, 3-methyl-1,5-pentanediol di(meth)acrylate, 1,6-hexanediol di(meth)acrylate, 2-butyl-2-ethyl-1,3-propanediol di(meth)acrylate, 1,9-nonanediol di(meth)acrylate, dimethylol-tricyclodecane di(meth)acrylate, hydroxypivalic acid neopentyl glycol di(meth)acrylate and tritetramethylene glycol di(meth)acrylate; trifunctional monomers such as pentaerythritol tri(meth)acrylate, trimethylolpropane tri(meth)acrylate, trimethylolethane tri(meth)acrylate di(meth)acrylate and dipentaerythritol tri(meth)acrylate; and tetrafunctional or more functional monomers such as pentaerythritol tetra(meth)acrylate, dipentaerythritol (meth)acrylate, dipentaerythritol penta(meth)acrylate and dipentaerythritol hexa(meth)acrylate. And, polyfunctional epoxy (meth)acrylate compounds and urethane (meth) acrylate compounds can also be suitably used. Further, a compound formed by modifying these polyfunctional (meth) acrylates can be used. These (meth)acrylate compounds may be used alone or in combination of two or more species.
As the above compound (B) having a difunctional or more functional unsaturated bond, among others, a

trifunctional or more functional caprolactone modified (meth)acrylate compound (B1) is suitable.
The present inventors made intense investigations, and consequently found that when the trifunctional or more functional caprolactone modified (meth)acrylate compound is used as a crosslinking monomer in a curable resin composition for resists, column spacers particularly having the high ability to recover from a deformation by compression, the flexibility and the low elastic modulus are obtained and found that when using such column spacers, it is possible to simultaneously inhibit "gravity defect" due to the expansion of the liquid crystal during heating and the "cold bubbling" due to the contraction of the liquid crystal at low temperatures. The reason for this is assumed to be that by using the trifunctional or more functional caprolactone modified (meth)acrylate compound as a crosslinking monomer, a straight chain structure providing the flexibility is moderately formed in a structure highly crosslinked for suppressing a plastic deformation.

Further, in the present description, the term "to modify a (meth)acrylate compound with caprolactone" means to introduce a ring-opening product or a ring-opening polymerization product of caprolactone between an alcohol-originated site of a (meth)acrylate compound and a (meth)acryloyl group, and the term "a caprolactone modified product of a (meth)acrylate compound" means a (meth)acrylate compound to which such caprolactone modification has been applied.

A specific method of modifying a (meth)acrylate compound with caprolactone is not particularly limited and includes, for example, a method of reacting alcohol with caprolactone at elevated temperatures in the presence of catalyst to synthesize caprolactone modified alcohol and then reacting this caprolactone modified alcohol with (meth) acrylic acid by esterification using a dehydrating solvent in the presence of catalyst; and a method of reacting (meth) acrylic acid with caprolactone to synthesize caprolactone modified (meth)acrylic acid and then reacting this caprolactone modified (meth)acrylic acid with alcohol by esterification.

As for the extent of modification of trifunctional or more functional caprolactone modified (meth)acrylate compound (B1), when number of functional groups of trifunctional or more functional (meth)acrylate compound, which is a base, is taken as n, it is preferred to modify the (meth)acrylate compound by introducing 0.5n to 5n moles of caprolactone with respect to 1 mole of trifunctional or more functional (meth)acrylate compound. When the amount of caprolactone to be introduced is less than 0.5n moles, the flexibility of column spacers to be obtained may becomes insufficient, and when it is more than 5n moles, the reactivity in exposing is deteriorated and patterning of spacers may becomes difficult. The amount of caprolactone to be introduced is more preferably 1n to 3n moles.

The above trifunctional or more functional caprolactone modified (meth)acrylate compound (B1) is not particularly limited but as for trifunctional compounds, a caprolactone modified compound of, for example, pentaerythritol tri (meth)acrylate, trimethylolpropane tri(meth)acrylate, trimethylolethane (meth)acrylate di(meth)acrylate or dipentaerythritol tri(meth)acrylate is suitable, and as for tetrafunctional or more functional compounds, a caprolactone modified compound of pentaerythritol tetra(meth)acrylate, ditrimethylolpropane tetra(meth)acrylate, dipentaerythritol (meth) tetraacrylate, dipentaerythritol penta(meth)acrylate or dipentaerythritol hexa(meth)acrylate is suitable. These trifunctional or more functional caprolactone modified (meth)acrylate compounds may be used alone or in combination of two or more species.

As the above trifunctional or more functional caprolactone modified (meth)acrylate compound (B1), there may be used a compound formed by caprolactone modifying a (meth)acrylate compound by the method described above or a commercially available product such as "KAYARAD DPCA-30", "KAYARAD DPCA-60", "KAYARAD DPCA-120" (caprolactone modified dipentaerythritol hexaacrylate), produced by Nippon Kayaku Co., Ltd., and "NK Ester AD-TMP-4CL" (caprolactone modified ditrimethylolpropane tetraacrylate), produced by SHIN-NAKAMURA CHEMICAL Co., Ltd.

The curable resin composition for column spacers of the present invention may contain a polyfunctional (meth) acrylate compound not caprolactone modified to the extent of not impairing the flexibility for the purpose of adjusting reactivity.

As the above compound (B) having a difunctional or more functional unsaturated bond, a compound (B2) having a polymerizable unsaturated bond and having a polyethylene glycol skeleton is also suitable.
The present inventors made intense investigations, and consequently found that in accordance with the column spacer formed by using the curable resin composition for column spacers containing the compound (B2) like this, it is possible to simultaneously inhibit "gravity defect" due to the expansion of the liquid crystal during heating and the "cold bubbling" due to the contraction of the liquid crystal at low temperatures. The reason for this is assumed to be that by using the compound having the polyethylene glycol skeleton, a plastic deformation is inhibited by a highly crosslinked structure and the flexibility is more provided for the polyethylene glycol skeleton.

The above compound (B2) is not particularly limited and includes, for example, polyethylene glycol (meth) acrylates such as diethylene glycol (meth)acrylate, triethylene glycol (meth)acrylate, tetraethylene glycol (meth)acrylate, hexaethylene glycol (meth)acrylate and nonaethylene glycol (meth)acrylate; and polyethylene glycol di(meth)acrylates such as diethylene glycol di(meth)acrylate, triethylene glycol di(meth)acrylate, tetraethylene glycol di(meth)acrylate, hexaethylene glycol di(meth)acrylate and nonaethylene glycol di(meth)acrylate. And, as a compound having a polymerizable unsaturated bond and having a trifunctional or more functional polyethylene glycol skeleton, there can also be used a polyethylene glycol modified compound of a polyfunctional (meth)acrylate compound such as trimethylolpropane

tri(meth)acrylate, ditrimethylolpropane tetra(meth)acrylate, pentaerythritol tri(meth)acrylate, pentaerythritol tetra(meth) acrylate, dipentaerythritol tetra(meth)acrylate, dipentaerythritol penta(meth)acrylate and dipentaerythritol hexa(meth) acrylate.

Among others, a compound having two or more polymerizable unsaturated bonds is suitable because it has a small effect on the compressive properties, resulting from a crosslinked structure, of column spacers formed by curing the curable resin composition for column spacers of the present invention.

As the above compound (B) having a difunctional or more functional unsaturated bond, the trifunctional or more functional caprolactone modified (meth)acrylate compound (B1) and the compound (B2) having the polymerizable unsaturated bond and having the polyethylene glycol skeleton may be used in combination.

By using the trifunctional or more functional caprolactone modified (meth)acrylate compound (B1) and the compound (B2) having the polymerizable unsaturated bond and having the polyethylene glycol skeleton in combination, it is possible to adequately adjust the compatibility of the above alkali-soluble high polymer compound (A) having a reactive functional group with the above compound (B) having a difunctional or more functional unsaturated bond, a compressive elastic modulus and a developing property.

A ratio of the trifunctional or more functional caprolactone modified (meth)acrylate compound (B1) and the compound (B2) having the polymerizable unsaturated bond and having the polyethylene glycol skeleton to be mixed on the occasion of using the compound (B1) and the compound (B2) in combination can be arbitrarily established.

A ratio of the above alkali-soluble high polymer compound (A) having a reactive functional group and the above compound (B) having a difunctional or more functional unsaturated bond to be mixed in the curable resin composition for column spacers of the present invention is not particularly limited but an amount of the above compound (B) having a difunctional or more functional unsaturated bond to be mixed has a preferable lower limit of 25 parts by weight and a preferable upper limit of 900 parts by weight with respect to 100 parts by weight of the alkali-soluble high polymer compound (A) having a reactive functional group. When the amount of the compound (B) to be mixed is less than 25 parts by weight, the curable resin composition is not adequately photo-cured and therefore there may be cases where it is impossible to form a pattern by photolithography, and when it is more than 900 parts by weight, there may be cases where a cured article after thermosetting cannot exert the elastic properties described above. A preferable lower limit is 100 parts by weight and a preferable upper limit is 500 parts by weight.

The curable resin composition for column spacers of the present invention contains a photoreaction initiator.

The above photoreaction initiator may be appropriately selected in response to the species of the above compound (B) having a difunctional or more functional unsaturated bond, and for example, publicly known photoreaction initiators such as benzoin, benzophenone, benzyl, thioxanthone and derivatives thereof can be used when a difunctional or more functional (meth)acrylate compound is used as the above compound (B) having a difunctional or more functional unsaturated bond. Specifically, there are given, for example, benzoin methyl ether, benzoin ethyl ether, benzoin isobutyl ether, Michler's ketone, (4-(methylphenylthio)phenyl)phenyl methanone, 2,2-dimethoxy-1,2-diphenylethane-1-one, 1-hydroxy-cyclohexyl-phenyl-ketone, 2-hydroxy-2-methyl-1-phenyl-propane-1-one, 1-(4-(2-hydroxy ethoxy)-phenyl)-2-hydroxy-2-methyl-1-propane-1-one, 2-methyl-1(4-(methylthio)phenyl)-2-morpholinopropane-1-one, 2-benzyl-2-dimethylamino-1-(4-morpholinophenyl)-butanone-1, bis(2,4,6-trimethylbenzoyl)-phenylphosphine oxide, bis(2,6-dimethoxybenzoyl)-2,4,4-trimethyl-pentylphosphine oxide, 2,4,6-trimethylbenzoyl-diphenyl-phosphine oxide, 2,4-diethylthioxanthone and 2-chlorothioxanthone. These photoreaction initiators may be used alone or in combination of two or more species.

An amount of the above photopolymerization initiator to be mixed in the curable resin composition for column spacers of the present invention has a preferable lower limit of 0.01 parts by weight and a preferable upper limit of 50 parts by weight with respect to 100 parts by weight of the above compound (B) having a difunctional or more functional unsaturated bond. When the amount of the photopolymerization initiator is less than 0.01 parts by weight, the curable resin composition may be not photo-cured, and when it is more than 50 parts by weight, there may be cases where alkaline development cannot be performed in photolithography. A more preferable lower limit is 0.05 parts by weight and a more preferable upper limit is 20 parts by weight.

It is preferred that the curable resin composition for column spacers of the present invention further contains a thermal crosslinking agent (C) having a functional group which can react with the alkali-soluble high polymer compound having a reactive functional group by crosslinking. When such a thermal crosslinking agent (C) is contained, if the above compound (B) having a difunctional or more functional unsaturated bond is crosslinked by a photoreaction initiator activated by irradiating light rays and the crosslinked compound (B) is provided with patterns by photolithography and then further heated, a cured article having the excellent elasticity and the excellent rate of recovery from a deformation by compression is obtained because the above alkali-soluble high polymer compound (A) having a reactive functional group reacts with the above thermal crosslinking agent (C) to provide a more strong crosslinking.

Particularly, when a substance not having a polymerizable functional group on a side chain is used as the alkali-soluble high polymer compound (A) having a reactive functional group, the thermal crosslinking agent (C) becomes an essential constituent.

The above thermal crosslinking agent (C) is not particularly limited, but for example, a thermal crosslinking agent (C1) having two or more blocked isocyanate groups is suitable.
The above thermal crosslinking agent (C1) having two or more blocked isocyanate groups is not particularly limited and includes, for example, substances obtained by blocking polyfunctional isocyanates comprising tolylene diisocyanate, 4,4-diphenylmethane diisocyanate, xylylene diisocyanate, hexamethylene diisocyanate, isophorone diisocyanate, methylenebis(4-cyclohexyl isocyanate), trimethylhexamethylene diisocyanate and oligomers thereof with an active methylene-based, oxime-based, lactam-based or alcohol-based blocking agent compound. These thermal crosslinking agents may be used alone or in combination of two or more species.
As a commercially available product of the thermal crosslinking agents having two or more blocked isocyanate groups like these, there are given, for example, Duranate 17B-60PX and Duranate E-402-B80T (both produced by Asahi Kasei Chemicals Corporation).

As the above thermal crosslinking agent (C), a thermal crosslinking agent (C2) having two or more epoxy groups is also suitably employed.
The above thermal crosslinking agent (C2) having two or more epoxy groups is not particularly limited and includes, for example, condensation products of epichlorohydrin and novolacs such as bisphenol F, bisphenol A, phenol novolac and cresol novolac, and epoxy compounds obtained by (co)polymerization of an alicyclic epoxy compound, a glycidyl ester epoxy compound, a glycidyl amine epoxy compound or glycidyl methacrylate.
As a commercially available product of the above thermal crosslinking agents (C2) having the epoxy groups, there are given, for example, EPICOAT 801, 802, 807, 815, 827, 828, 152, 154 and 180S65 produced by Japan Epoxy Resins Co., Ltd. and Adeka Resin EP-4100, EP-4340 produced by Asahi Denka K.K.
These thermal crosslinking agents may be used alone or in combination of two or more species.

An amount of the above thermal crosslinking agent (C) to be mixed in the curable resin composition for column spacers of the present invention has a preferable lower limit of 0.01 parts by weight and a preferable upper limit of 50 parts by weight with respect to 100 parts by weight of the above alkali-soluble high polymer compound (A) having a reactive functional group. When the amount of the thermal crosslinking agent is less than 0.01 parts by weight, the curable resin composition may be not adequately heat-cured, and when it is more than 50 parts by weight, there may be cases where the degree of crosslinking of a cured article obtained may become too high and the cured article may not satisfy the elastic properties described above. A more preferable lower limit is 0.05 parts by weight and a more preferable upper limit is 20 parts by weight.

The curable resin composition for column spacers of the present invention may further contain a reaction auxiliary in order to mitigate reaction interference by oxygen. By using such a reaction auxiliary in combination with a photoreaction initiator of hydrogen abstraction type, a curing rate in light irradiation can be improved.
The above reaction auxiliary is not particularly limited and includes, for example, amines such as n-butylamine, di-n-butylamine, triethylamine, triethylenetetramine, ethyl p-dimethylaminobenzoate and isoamyl p-dimethylaminobenzoate, phosphines such as tri-n-butylphosphine, and sulfones such as s-benzylisothironium-p-toluenesulfinate. These reaction auxiliaries may be used alone or in combination of two or more species.

The curable resin composition for column spacers of the present invention may be diluted by a diluent in order to adjust viscosity. The above diluent may be selected considering the compatibility with the curable resin composition for column spacers of the present invention, a method of coating, film uniformity in drying and a drying efficiency, and it is not particularly limited, but when the curable resin composition for column spacers of the present invention is coated with a spin coater or a slit coater, organic solvents such as methyl cellosolve, ethyl cellosolve, ethyl cellosolve acetate, diethylene glycol dimethyl ether, propylene glycol monoethyl ether acetate and isopropyl alcohol are suitable. These diluents may be used alone or in combination of two or more species.

The curable resin composition for column spacers of the present invention may contain publicly known additives such as a silane coupling agent and the like as required in order to enhance the adhesion to a substrate.

A method of producing the curable resin composition for column spacers of the present invention is not particularly limited and includes, for example, a method of mixing the above alkali-soluble high polymer compound (A) having a reactive functional group, the compound (B) having a difunctional or more functional unsaturated bond, the photoreaction initiator, and the thermal crosslinking agent (C) and the diluent, which are used as required, by a publicly known method.

A method of producing the column spacers using the curable resin composition for column spacers of the present invention will be described.
When producing the column spacers using the curable resin composition for column spacers of the present invention, the curable resin composition for column spacers of the present invention is first coated onto a substrate so as to have a specified thickness to form a coat. A method of applying the resin composition is not particularly limited, and publicly known coating methods such as spin coating, slit coating, spray coating, dip coating and bar coating can be employed.

Next, active light such as ultraviolet light is irradiated to the obtained coat through a mask on which a desired pattern is formed. Thereby, in a portion irradiated with light, reacting with a crosslinkable component and a photoreaction

initiator, which are contained in the curable resin composition for column spacers of the present invention and they are photocured. By developing this phtocuring coat, it is possible to obtain a desired pattern consisting of a curable resin composition for column spacers phtocuring on the substrate. When the curable resin composition for column spacers of the present invention contains the thermal crosslinking agent (C1) such as a compound having two or more blocked isocyanate groups, the patterns on the substrate is further heated to allow the crosslinking reaction to proceed.

The column spacer, in which the curable resin composition for column spacers of the present invention is used, can form a liquid crystal display element which does not produce color irregularity due to gravity defect and cold bubbling and exhibits high durability when the column spacer is used as a spacer for maintaining a gap between two glass substrates at a constant distance in a liquid crystal display element.

The column spacer formed by using the curable resin composition for column spacers of the present invention also constitutes the present invention.

The liquid crystal display element formed by using the column spacers of the present invention also constitutes the present invention.

Effects of the Invention

In accordance with the present invention, it is possible to provide the column spacer capable of forming a liquid crystal display element which does not produce the color irregularity due to gravity defect and the cold bubbling and exhibits the high durability when the column spacer is used as a spacer for maintaining a gap between two glass substrates at a constant distance in a liquid crystal display element, the liquid crystal display element using the column spacers and the curable resin composition for column spacers from which the column spacer can be produced.

And, the curable resin composition for column spacers of the present invention can also be employed as a resin for a protrusion of a liquid crystal display element of a vertical alignment (VA) mode in which a protrusion is provided on a substrate and the alignment of a liquid crystal is regulated by this protrusion. In doing so, a protrusion for the alignment of a liquid crystal can be formed concurrently with a photo resist treatment step for producing column spacers.

Best Mode for Carrying Out the Invention

Hereinafter, the present invention will be described in more detail by way of examples, but the present invention is not limited to these examples.

(Experimental Example 1)

(1) Synthesis of alkali-soluble high polymer compound having a reactive functional group

Into a three liter separable flask equipped with a cooling tube and a stirrer, 60 parts by weight of diethylene glycol dimethyl ether (DMDG) and 3 parts by weight of 2,2-azobis(2,4-dimethyl)valeronitrile were charged as a solvent, and after the mixed solvent was heated to 70˚C in an atmosphere of nitrogen, 12 parts by weight of methyl methacrylate, 8 parts by weight of methacrylic acid, 14 parts by weight of n-butyl methacrylate, 4 parts by weight of 2-hydroxyethyl methacrylate and 1 part by weight of n-dodecyl mercaptan were continuously added dropwise over 5 hours while stirring the content of the flask. Then, the mixture was kept at 70˚C for 1 hour and then heated to 90˚C, and polymerization was continued for 3 hours to obtain a raw material polymer.

Next, to the resulting solution of the raw material polymer, 5 parts by weight of 2-methacryloyloxyethyl isocyanate (produced by SHOWA DENKO K.K., "karenzMOI") and 0.01 parts by weight of dibutyltin laurate were added, and the mixture was heated and stirred at 50˚C to obtain a solution of an alkali-soluble high polymer compound having a reactive functional group.

A reaction was continued until a peak of 2200 $cm^{-1}$ by an isocyanate group disappeared in an infrared absorption spectrum (IR) while monitored the progress of a reaction with the infrared absorption spectrum.

The obtained copolymer solution was sampled and its molecular weight was measured with gel permeation chromatography (GPC), and consequently the weight average molecular weigh (Mw) of the copolymer was 15000.

(2) Preparation of curable resin composition for column spacers

100 parts by weight of the resulting solution of an alkali-soluble high polymer compound having a reactive functional group, 80 parts by weight of caprolactone modified ditrimethylolpropane tetraacrylate (produced by SHIN-NAKAMURA CHEMICAL Co., Ltd., "NK Ester AD-TMP-4CL"), 5 parts by weight of Irgacure907 (produced by Ciba Specialty Chemicals K.K.) and 5 parts by weight of KAYACURE DETX-S (produced by Nippon Kayaku Co., Ltd.) as a photoreaction initiator, respectively, and 8 parts by weight of a thermal crosslinking agent (produced by Asahi Kasei

Chemicals Corporation, "Duranate 17B-60PX") were mixed, and to this, 120 parts by weight of diethylene glycol dimethyl ether was further added as a solvent and the mixture was mixed to prepare a curable resin composition for column spacers.

(Experimental Example 2)

50 parts by weight of the solution of an alkali-soluble high polymer compound having a reactive functional group, obtained in Example 1, 60 parts by weight of caprolactone modified dipentaerythritol hexaacrylate (produced by Nippon Kayaku Co., Ltd., "DPCA-120"), 6 parts by weight of a photoreaction initiator (produced by Ciba Specialty Chemicals K.K., "Irgacure369") and 100 parts by weight of diethylene glycol dimethyl ether as a solvent were mixed to prepare a curable resin composition for column spacers, and further a liquid crystal display element was produced by following the same method as in Experimental Example 1.

(Experimental Example 3)

90 parts by weight (solid matter 40 parts by weight) of CYCLOMER P ACA250 (produced by DAICEL CHEMICAL INDUSTRIES, LTD.) as an alkali-soluble (meth)acrylic copolymer having an acrylic group and a carboxyl group on a side chain, 80 parts by weight of caprolactone modified dipentaerythritol hexaacrylate (produced by Nippon Kayaku Co., Ltd., KAYARAD DPCA-120), 15 parts by weight of a photoreaction initiator (produced by Ciba Specialty Chemicals K.K., Irgacure369) and 130 parts by weight of diethylene glycol dimethyl ether as a solvent were mixed to prepare a curable resin composition for column spacers.

The obtained curable resin composition for column spacers was applied onto a glass substrate, on which a transparent conductive film was formed, by spin coating and dried at 80˚C for 3 minutes to obtain a coat. After irradiating the obtained coat with ultraviolet light of 200 mJ/cm$^2$ through a mask having a pattern of dots 30 $\mu$m square, the coat was developed with a 0.04% KOH solution for 60 seconds and washed with pure water for 30 seconds to form a pattern of column spacers. After the pattern of column spacers was baked at 220˚C for 1 hour, each column spacer has a cross-sectional area of 30 $\mu$m by 30 $\mu$m (900 $\mu$m$^2$) and a height of 4.5 $\mu$m.

A sealing agent (produced by Sekisui Chemical Co., Ltd.) was applied onto a glass substrate, on which the obtained column spacer was formed, in the form of a rectangular frame with a dispenser. Subsequently, small droplets of liquid crystal (produced by CHISSO CORPORATION, JC-5004LA) were added dropwise and applied onto the whole surface of the glass substrate within the frame, and on this, other glass substrate was immediately overlaid and ultraviolet light was irradiated to the sealed portion for 60 seconds at the intensity of 50 mW/cm$^2$ using a high-voltage mercury lamp. After this, by annealing the liquid crystal at 120˚C for 1 hour, and the sealing agent was thermally cured to prepare a liquid crystal display element.

(Experimental Example 4)

75 parts by weight (solid matter 40 parts by weight) of CYCLOMER P ACA230AA (produced by DAICEL CHEMICAL INDUSTRIES, LTD.) as an alkali-soluble (meth)acrylic copolymer having an acrylic group and a carboxyl group on a side chain, 80 parts by weight of caprolactone modified ditrimethylolpropane tetraacrylate (produced by SHIN-NAKAMURA CHEMICAL Co., Ltd., NK Ester AD-TMP-4CL), 15 parts by weight of a photoreaction initiator (produced by Ciba Specialty Chemicals K.K., Irgacure369), 8 parts by weight of a thermal crosslinking agent (produced by Asahi Kasei Chemicals Corporation, Duranate E-402-B80T) and 145 parts by weight of diethylene glycol dimethyl ether as a solvent were mixed to prepare a curable resin composition for column spacers.
Column spacers and a liquid crystal display element were obtained by following the same method as in Experimental Example 3 except for using the resulting curable resin composition for column spacers.

(Experimental Example 5)

(1) Modification of carboxyl group-containing acrylic copolymer with radical polymerizable group-containing isocyanate compound

Into a three liter separable flask equipped with a stirrer, a thermometer, a reflux cooling tube, a dropping funnel and a nitrogen gas inlet tube, 1000 g of CYCLOMER P (produced by DAICEL CHEMICAL INDUSTRIES, LTD., ACA-250) as an alkali-soluble (meth)acrylic copolymer, 0.5 g of dibutyltin laurate, 0.05 g of hydroquinone and 500 g of diethylene glycol dimethyl ether were charged, and the mixture was heated to 40˚C, and then to this, 94.6 g (represent 50 mole% of a hydroxyl group in CYCLOMER P) of 2-methacryloylethyl isocyanate was added dropwise over 2 hours and the mixture was aged at 40˚C for 3 hours.
The obtained reaction solution had solid matter of 35% by weight, an resin acid value of 60 mgKOH/g and a weight

average molecular weigh of 11500 on the polystyrene equivalent basis.

(2) Preparation of photo-curable resin composition

Into 100 parts by weight of the resulting reaction solution, 80 parts by weight of caprolactone modified dipentaerythritol hexaacrylate (produced by Nippon Kayaku Co., Ltd., KAYARAD DPCA-120), 15 parts by weight of a photopolymerization initiator (produced by Ciba Specialty Chemicals K.K., Irgacure369), 8 parts by weight of a thermal crosslinking agent (produced by Asahi Kasei Chemicals Corporation, Duranate E-402-B80T) and 120 parts by weight of diethylene glycol dimethyl ether as a solvent were mixed to prepare a photo-curable resin composition.

(3) Formation of column spacer

The obtained curable resin composition for column spacers was applied onto a glass substrate, on which a transparent conductive film was formed, by spin coating and dried at 100˚C for 2 minutes to obtain a coat. After irradiating the obtained coat with ultraviolet light of 150 mJ/cm$^2$ through a mask having a pattern of dots 20 μm square, the coat was developed with a 0.04% KOH solution for 90 seconds and washed with pure water for 30 seconds to form a pattern of column spacers. After the pattern of column spacers was baked at 220˚C for 30 minutes, each column spacer has a cross-sectional area of 20 μm by 20 μm (400μ m$^2$) and a height of 3.0 μm.

(4) Production of liquid crystal display element

A sealing agent (produced by Sekisui Chemical Co., Ltd.) was applied onto a glass substrate, on which the obtained column spacer was formed, in the form of a rectangular frame with a dispenser. Next, small droplets of liquid crystal (produced by CHISSO CORPORATION, JC-5004LA) were added dropwise and applied onto the whole surface of the glass substrate within the frame, and on this, other glass substrate was immediately overlaid and ultraviolet light was irradiated to the sealed portion for 60 seconds at the intensity of 50 mW/cm$^2$ using a high-voltage mercury lamp. After this, by annealing the liquid crystal at 120˚C for 1 hour, the sealing agent was thermally cured to prepare a liquid crystal display element.

(Experimental Example 6)

Into a three liter separable flask equipped with a stirrer, a thermometer, a reflux cooling tube, a dropping funnel and a nitrogen gas inlet tube, 1000 g of CYCLOMER P (produced by DAICEL CHEMICAL INDUSTRIES, LTD., ACA-250) as an alkali-soluble (meth)acrylic copolymer, 58.0 g (represent 50 mole% of a carboxyl group in CYCLOMER P) of α-olefin epoxide (produced by DAICEL CHEMICAL INDUSTRIES, LTD., AOE-X24), 0.5 g of triphenylphosphine, 0.05 g of hydroquinone and 500 g of diethylene glycol dimethyl ether were charged, and the mixture was reacted at 100˚C for 10 hours.
The obtained reaction solution had solid matter of 33.5%, a resin acid value of 42 mgKOH/g and a weight average molecular weigh of 11600 on the polystyrene equivalent basis.
Then, column spacers and a liquid crystal display element were obtained by following the same method as in Experimental Example 5 except for using the obtained reaction solution.

(Experimental Example 7)

(1) Synthesis of alkali-soluble high polymer compound

Into a three liter separable flask equipped with a cooling tube and a stirrer, 60 parts by weight of diethylene glycol dimethyl ether (DMDG) and 3 parts by weight of 2,2-azobis(2,4-dimethyl)valeronitrile were charged as a solvent, and after the mixed solvent was heated to 70˚C in an atmosphere of nitrogen, 10 parts by weight of methacrylic acid, 15 parts by weight of n-butyl methacrylate, 15 parts by weight of methyl methacrylate and 1 part by weight of n-dodecyl mercaptan were continuously added dropwise over 5 hours while stirring the content of the flask. Then, the mixture was kept at 70˚C for 1 hour and then heated to 90˚C, and polymerization was continued for 3 hours to obtain an alkali-soluble high polymer compound.

The obtained copolymer solution was sampled and its molecular weight was measured with gel permeation chromatography (GPC), and consequently the weight average molecular weigh (Mw) of the copolymer was 14000.

(2) Preparation of curable resin composition for column spacers

50 parts by weight of the obtained solution of an alkali-soluble high polymer compound, 60 parts by weight of caprolactone modified dipentaerythritol hexaacrylate (produced by Nippon Kayaku Co., Ltd., "DPCA-120"), 6 parts by weight of a photoreaction initiator (produced by Ciba Specialty Chemicals K.K., "Irgacure369") and 100 parts by weight of diethylene glycol dimethyl ether as a solvent were mixed to prepare a curable resin composition for column spacers, and further a liquid crystal display was produced by following the same method as in Experimental Example 1.

(Experimental Example 8)

50 parts by weight of the solution of an alkali-soluble high polymer compound having a reactive functional group, obtained in Example 1, 60 parts by weight of dipentaerythritol hexaacrylate (produced by KYOEISHA CHEMICAL Co., Ltd., "LIGHT-ACRYLATE DPE-6A"), 6 parts by weight of a photoreaction initiator (produced by Ciba Specialty Chemicals K.K., "Irgacure369") and 100 parts by weight of diethylene glycol dimethyl ether as a solvent were mixed to prepare a curable resin composition for column spacers, and further a liquid crystal display element was produced by following the same method as in Experimental Example 1.

(Experimental Example 9)

Into 100 parts by weight of the reaction solution obtained in Experimental Example 5, 80 parts by weight of dipentaerythritol hexaacrylate (produced by KYOEISHA CHEMICAL Co., Ltd., DPHA), 15 parts by weight of a photopolymerization initiator (produced by Ciba Specialty Chemicals K.K., Irgacure369), 8 parts by weight of a thermal crosslinking agent (produced by Asahi Kasei Chemicals Corporation, Duranate E-402-B80T) and 120 parts by weight of diethylene glycol dimethyl ether as a solvent were mixed. Then, column spacers and a liquid crystal display element were obtained by following the same method as in Experimental Example 5.

(Evaluation)

The column spacers and the liquid crystal display elements obtained in Experimental Examples 1 to 9 were evaluated according to the following methods.
The results are shown in Table 1.

(1) Evaluation of column spacer

(1-1) Measurement of elastic modulus and rate of recovery in compressing by 15% at 25˚C
In a room adjusted to 25˚C, the column spacers were compressed at a load application rate of 10 mN/s until its height reaches 85% of its initial height $H_0$. Here, a column spacer height in applying a load of 10 mN is taken as $H_1$, a column spacer height corresponding to 85% of $H_0$ is taken as $H_2$ and a load at the moment when the column spacer height reached $H_2$ is taken as F. Next, after this load F was held for 5 seconds to cause deformation in the column spacer at constant load, the load is removed at a load application rate of 10 mN/s, and the recovery from deformation of the column spacer height by elastic recovery was measured. The column spacer height at the moment when deformation by compression reaches the maximum in this process was taken as $H_3$, and a column spacer height in applying a load of 10 mN in a process of recovering deformation of the column spacer was taken as $H_4$. Using the obtained respective values, the elastic modulus in compressing by 15% and the rate of recovery in deforming by compressing by 15% were calculated from the above equations (2) and (4).

(1-2) Measurement of elastic modulus in compressing by 15% at 60˚C and 120˚C
On a heating stage set at 60˚C and 120˚C, the column spacers were compressed at a load application rate of 10 mN/s until its height reaches 85% of its initial height $H_0$. Here, a load of 10 mN was applied and a column spacer height corresponding to 85% of $H_0$ is taken as $H_1$ and a load at the moment when the column spacer height reached $H_1$ is taken as F. Using the obtained respective values, the compression elastic modulus E in compressing by 15% was calculated from the above equation (2).

(1-3) Measurement of rate of change of elastic modulus after repeating compressing at 25˚C
In a room adjusted to 25˚C, a compression test, in which the column spacers were compressed at a load application rate of 10 mN/s until its height reaches 85% of its initial height $H_0$ and a load (F) at this moment was held for 5 seconds to cause deformation in the column spacer at constant load and then the load is removed at a load application rate of 10 mN/s, was performed, and the elastic modulus $E_1$ in the first compression was determined from the above equation (2). Then, the same compression test was performed repeatedly on the same column spacer and an elastic modulus $E_5$ in the fifth compression was determined and the rate of change of an elastic modulus was calculated from the above equation (3).

(1-4) Measurement of P value ($\{(E_{120}-E_{25})/E_{25}\}\times100$)
In a room adjusted to 25˚C, the column spacers were compressed at a load application rate of 10 mN/s until its height reaches 85% of its initial height $H_0$. Here, a column spacer height corresponding to 85% of $H_0$ is taken as $H_1$ and a load at the moment when the column spacer height reached $H_1$ is taken as F. Using the obtained respective values, the initial compression elastic modulus $E_{25}$ in compressing by 15% was calculated from the above equation (2) .
On the other hand, the column spacers were compressed by 15% at 120˚C and returned to the original state once, and further they were compressed by 15% in a room adjusted to 25˚C, and a compression elastic modulus $E_{120}$ was determined by the following the same procedure as in $E_{25}$.
Based on the derived $E_{25}$ and $E_{120}$, P value was determined from the following equation (12):

$$P = \{(E_{120}-E_{25})/E_{25}\}\times100 \qquad (12).$$

(1-5) Measurement of coefficient of linear expansion
The glass substrate on which column spacers are formed, obtained in Experimental Examples, was placed on a stage capable of heating and cooling, and in a temperature raising process from 25˚C to 100˚C, a height of the column spacer at each temperature in the case where the surface temperature of the glass substrate is 25˚C, 40˚C, 60˚C, 80˚C and 100˚C was measured with an atomic force microscope, and further in a temperature lowering process from 100˚C to 25˚C, a height of the column spacer at each temperature in the case where the surface temperature of the glass substrate is 80˚C, 60˚C, 40˚C and 25˚C was measured again, and a coefficient of linear expansion in the direction of the height of the column spacer was determined from a gradient of an approximate straight line obtained by plotting all measurements on a height versus temperature graph.

(1-6) Evaluation of resolution
Sharpness of a pattern's edge of the column spacers and roughness of the pattern surface were observed with an optical microscope and rated according to the following criteria.

○: adequate sharp in practical use
◎: extremely sharp

(2) Evaluation of liquid crystal display element

Each liquid crystal display element was turned on and displayed. A display screen was visually observed and uniformity of the cell gap was rated according to the following criteria.
And, the liquid crystal display element was left standing at 60˚C for two days in a state of standing vertically. After left standing, the liquid crystal display element was located between crossed nicols and a displayed image was visually observed and the occurrence of gravity defect was rated according to the following criteria.
Further, after the liquid crystal display element was left standing at 0˚C for 24 hours, the liquid crystal display element was located between crossed nicols and a displayed image was visually observed and the occurrence of cold bubbling was rated according to the following criteria.
Evaluation of cell gap

○: uniform
×: there is color irregularity

Evaluation of gravity defect

○: uniform
×: there is color irregularity

Evaluation of cold bubbling

○: there is no foaming
×: there is foaming

Table 1

| | Column spacer | | | | | | | | Liquid crystal display element | | |
|---|---|---|---|---|---|---|---|---|---|---|---|
| | Deformation by compressing by 15% at 25°C | | Elastic modulus in deformation by compressing by 15% at 60°C (GPa) | Elastic modulus in deformation by compressing by 15% at 120°C (GPa) | Rate of change of elastic modulus after repeating compressing at 25°C (%) | P value | Coefficient of linear expansion (/°C) | Resolution | Gap | Gravity defect | Cold bubbling |
| | Elastic modulus (GPa) | Rate of recovery (%) | | | | | | | | | |
| Experimental Example 1 | 0.65 | 71.5 | 0.37 | 0.26 | 3.7 | 6.2 | $2.7 \times 10^{-4}$ | ○ | ○ | ○ | ○ |
| Experimental Example 2 | 0.51 | 65.3 | 0.29 | 0.20 | 2.8 | 7.8 | $3.2 \times 10^{-4}$ | ○ | ○ | ○ | ○ |
| Experimental Example 3 | 0.40 | 78.0 | 0.23 | 0.16 | 5.0 | 7.5 | $3.7 \times 10^{-4}$ | ○ | ○ | ○ | ○ |
| Experimental Example 4 | 0.70 | 82.1 | 0.40 | 0.28 | 4.1 | 5.7 | $2.5 \times 10^{-4}$ | ○ | ○ | ○ | ○ |
| Experimental Example 5 | 0.42 | 70.5 | 0.24 | 0.17 | 2.2 | 4.8 | $3.6 \times 10^{-4}$ | ○ | ○ | ○ | ○ |
| Experimental Example 6 | 0.72 | 72.2 | 0.41 | 0.29 | 42 | 6.9 | $2.5 \times 10^{-4}$ | ○ | ○ | ○ | ○ |
| Experimental Example 7 | 0.50 | 39.2 | 0.29 | 0.20 | 10.0 | 12.0 | $3.2 \times 10^{-4}$ | ○ | ○ | × | ○ |
| Experimental Example 8 | 2.00 | 92.0 | 1.09 | 0.75 | 12.7 | 14.0 | $4.2 \times 10^{-5}$ | ○ | ○ | × | × |
| Experimental Example 9 | 1.68 | 91.0 | 0.92 | 0.63 | 10.6 | 12.5 | $7.8 \times 10^{-5}$ | ○ | ○ | × | × |

(Experimental Example 10)

(1) Synthesis of alkali-soluble high polymer compound

Into a three liter separable flask, 60 parts by weight of diethylene glycol dimethyl ether was charged as a solvent and heated to 90°C in an atmosphere of nitrogen, and then 10 parts by weight of methacrylic acid, 10 parts by weight of 2-(o-[1'-methyl-propylideneamino]carboxyamino)ethyl (meth)acrylate (produced by SHOWA DENKO K.K., "karenz-MOI-BM"), 14 parts by weight of n-butyl methacrylate, 6 parts by weight of 2-ethylhexyl acrylate, 2 parts by weight of 2,2-azobis(2,4-dimethyl)valeronitrile and 0.8 parts by weight of n-dodecyl mercaptan were continuously added dropwise over 3 hours.
Then, the mixture was kept at 90°C for 30 minutes and then heated to 105°C, and polymerization was continued for 3 hours to obtain a solution of an alkali-soluble high polymer compound.
The obtained alkali-soluble high polymer compound was sampled and its molecular weight was measured by gel permeation chromatography (GPC), and consequently the weight average molecular weigh (Mw) was about 20000.

(2) Preparation of curable resin composition for column spacers

100 parts by weight of the resulting solution of an alkali-soluble high polymer compound, 80 parts by weight of caprolactone modified pentaerythritol hexaacrylate (produced by Nippon Kayaku Co., Ltd., "DPCA-120"), 10 parts by weight of a photoreaction initiator (produced by Ciba Specialty Chemicals K.K., "Irgacure369") and 120 parts by weight of diethylene glycol dimethyl ether as a solvent were mixed to prepare a curable resin composition for column spacers.

(3) Preparation of column spacers

The obtained curable resin composition for column spacers was applied onto a glass substrate, on which a transparent conductive film was formed, by spin coating and dried at 80°C for 3 minutes to obtain a coat. After irradiating the obtained coat with ultraviolet light of 200 $mJ/cm^2$ through a mask having a pattern of dots 30 μm square, the coat was developed with a 0.04% KOH solution for 60 seconds and washed with pure water for 30 seconds to form a pattern of column spacers. After the pattern of column spacers was baked at 220°C for 1 hour, each column spacer has a cross-sectional area of 30 μm by 30 μm (900 $\mu m^2$) and a height of 4.5 μm.

(4) Production of liquid crystal display element

A sealing agent (produced by Sekisui Chemical Co., Ltd.) was applied onto a glass substrate, on which the obtained column spacer was formed, in the form of a rectangular frame with a dispenser. Subsequently, small droplets of liquid crystal (produced by CHISSO CORPORATION, "JC-5004LA") were added dropwise and applied onto the whole surface of the glass substrate within the frame, and on this, other glass substrate was immediately overlaid and ultraviolet light was irradiated to the sealed portion for 60 seconds at the intensity of 50 $mW/cm^2$ using a high-voltage mercury lamp. After this, by annealing the liquid crystal at 120°C for 1 hour and the sealing agent was thermally cured to prepare a liquid crystal display element.

(Experimental Example 11)

(1) Polymerization of alkali-soluble high polymer compound

Into a three liter separable flask, 60 parts by weight of diethylene glycol dimethyl ether was charged as a solvent and heated to 90°C in an atmosphere of nitrogen, and then 7 parts by weight of methacrylic acid, 10 parts by weight of 2-(o-[1'-methyl-propylideneamino]carboxyamino)ethyl (meth)acrylate (produced by SHOWA DENKO K.K., "karenzMOI-BM"), 3 parts by weight of methyl methacrylate, 14 parts by weight of n-butyl methacrylate, 6 parts by weight of 2-hydroxyethyl methacrylate, 2 parts by weight of 2,2-azobis(2,4-dimethyl)valeronitrile and 0.8 parts by weight of n-dodecyl mercaptan were continuously added dropwise over 3 hours.
Then, the mixture was kept at 90°C for 30 minutes and then heated to 105°C, and polymerization was continued for 3 hours to obtain a solution of an alkali-soluble high polymer compound.
The obtained alkali-soluble high polymer compound was sampled and its molecular weight was measured by gel permeation chromatography (GPC), and consequently the weight average molecular weigh (Mw) was about 22000.

(2) Preparation of curable resin composition for column spacers

100 parts by weight of the resulting solution of an alkali-soluble high polymer compound, 80 parts by weight of caprolactone modified ditrimethylolpropane tetraacrylate (produced by SHIN-NAKAMURA CHEMICAL Co., Ltd., NK Ester AD-TMP-4CL), 10 parts by weight of a photoreaction initiator (produced by Ciba Specialty Chemicals K.K., "Irgacure369") and 120 parts by weight of diethylene glycol dimethyl ether as a solvent were mixed to prepare a curable resin composition for column spacers. Column spacers and a liquid crystal display element were obtained by following the same method as in Experimental Example 10 except for using the obtained curable resin composition for column spacers.

(Experimental Example 12)

(1) Polymerization of alkali-soluble high polymer compound

Into a three liter separable flask, 60 parts by weight of diethylene glycol dimethyl ether was charged as a solvent and heated to 90˚C in an atmosphere of nitrogen, and then 10 parts by weight of methacrylic acid, 10 parts by weight of methyl methacrylate, 14 parts by weight of n-butyl methacrylate, 6 parts by weight of 2-ethylhexyl acrylate, 2 parts by weight of 2,2-azobis(2,4-dimethyl)valeronitrile and 0.8 parts by weight of n-dodecyl mercaptan were continuously added dropwise over 3 hours.
Then, the mixture was kept at 90˚C for 30 minutes and then heated to 105˚C, and polymerization was continued for 3 hours to obtain a solution of an alkali-soluble high polymer compound.
The obtained alkali-soluble high polymer compound was sampled and its molecular weight was measured by gel permeation chromatography (GPC), and consequently the weight average molecular weigh (Mw) was about 20000.

(2) Preparation of curable resin composition for column spacers

100 parts by weight of the resulting solution of an alkali-soluble high polymer compound, 80 parts by weight of dipentaerythritol hexaacrylate (produced by KYOEISHA CHEMICAL Co., Ltd., "DPE-6A"), 8 parts by weight of Irgacure907 (produced by Ciba Specialty Chemicals K.K.) and 8 parts by weight of DETX-S (produced by Nippon Kayaku Co., Ltd.) as a photoreaction initiator, respectively, and 120 parts by weight of diethylene glycol dimethyl ether as a solvent were mixed to prepare a curable resin composition for column spacers. Column spacers and a liquid crystal display element were obtained by following the same method as in Experimental Example 10 except for using the obtained curable resin composition for column spacers.

(Experimental Example 13)

100 parts by weight of the solution of an alkali-soluble high polymer compound obtained in Experimental Example 12, 80 parts by weight of caprolactone modified pentaerythritol tetraacrylate (produced by Nippon Kayaku Co., Ltd., "DPCA-120"), 10 parts by weight of a photoreaction initiator (produced by Ciba Specialty Chemicals K.K., "Irgacure369") and 120 parts by weight of diethylene glycol dimethyl ether as a solvent were mixed to prepare a curable resin composition for column spacers. Column spacers and a liquid crystal display element were obtained by following the same method as in Experimental Example 10 except for using the obtained curable resin composition for column spacers.

(Experimental Example 14)

Into a three liter separable flask, 60 parts by weight of diethylene glycol dimethyl ether was charged as a solvent and heated to 90˚C in an atmosphere of nitrogen, and then 7 parts by weight of methacrylic acid, 13 parts by weight of methyl methacrylate, 14 parts by weight of n-butyl methacrylate, 6 parts by weight of 2-hydroxyethyl methacrylate, 2 parts by weight of 2,2-azobis(2,4-dimethyl)valeronitrile and 0.8 parts by weight of n-dodecyl mercaptan were continuously added dropwise over 3 hours. Then, the mixture was kept at 90˚C for 30 minutes and then heated to 105˚C, and polymerization was continued for 3 hours to obtain a solution of an alkali-soluble high polymer compound.
The obtained alkali-soluble high polymer compound was sampled and its molecular weight was measured by gel permeation chromatography (GPC), and consequently the weight average molecular weigh (Mw) was about 20000.

(2) Preparation of curable resin composition for column spacers

100 parts by weight of the resulting solution of an alkali-soluble high polymer compound, 80 parts by weight

of caprolactone modified ditrimethylolpropane tetraacrylate (produced by SHIN-NAKAMURA CHEMICAL Co., Ltd., NK Ester AD-TMP-4CL), 10 parts by weight of a photoreaction initiator (produced by Ciba Specialty Chemicals K.K., "Irgacure369") and 120 parts by weight of diethylene glycol dimethyl ether as a solvent were mixed to prepare a curable resin composition for column spacers. Column spacers and a liquid crystal display element were obtained by following the same method as in Experimental Example 10 except for using the obtained curable resin composition for column spacers.

(Evaluation)

The column spacers and the liquid crystal display elements obtained in Experimental Examples 10 to 14 were evaluated according to the same methods as described above.
The results are shown in Table 2.
Table 2

| | Column spacer | | | | | | | | Liquid crystal display element | | |
|---|---|---|---|---|---|---|---|---|---|---|---|
| | Deformation by compressing by 15% at 25°C | | Elastic modulus in deformation by compressing by 15% at 60°C (GPa) | Elastic modulus in deformation by compressing by 15% at 120°C (GPa) | Rate of change of elastic modulus after repeating compressing at 25°C (%) | P value | Coefficient of linear expansion (/°C) | Resolution | Gap | Gravity defect | Cold bubbling |
| | Elastic modulus (GPa) | Rate of recovery (%) | | | | | | | | | |
| Experimental Example 10 | 0.62 | 71.8 | 0.35 | 0.25 | 3.5 | 4.8 | $2.8 \times 10^{-4}$ | ○ | ○ | ○ | ○ |
| Experimental Example 11 | 0.73 | 65.0 | 0.42 | 0.29 | 4.3 | 5.5 | $2.5 \times 10^{-4}$ | ○ | ○ | ○ | ○ |
| Experimental Example 12 | 1.80 | 55.2 | 0.98 | 0.65 | 11.4 | 12.8 | $6.4 \times 10^{-5}$ | ○ | ○ | × | × |
| Experimental Example 13 | 0.53 | 42.1 | 0.30 | 0.21 | 13.2 | 15.1 | $3.1 \times 10^{-4}$ | ○ | ○ | × | ○ |
| Experimental Example 14 | 1.75 | 53.2 | 0.90 | 0.61 | 11.1 | 13.1 | $6.9 \times 10^{-5}$ | ○ | ○ | × | × |

(Experimental Example 15)

Into a three liter separable flask equipped with a cooling tube and a stirrer, 60 parts by weight of diethylene glycol dimethyl ether (DMDG) and 2 parts by weight of 2,2-azobis(2,4-dimethyl)valeronitrile were charged as a solvent, and after the mixed solvent was heated to 70˚C in an atmosphere of nitrogen, 12 parts by weight of styrene, 8 parts by weight of methacrylic acid, 20 parts by weight of glycidyl methacrylate and 1 part by weight of n-dodecyl mercaptan were continuously added dropwise over 5 hours while stirring the content of the flask. Then, the mixture was kept at 70˚C for 1 hour and then heated to 90˚C, and polymerization was continued for 3 hours.
The obtained solution of alkali-soluble (meth)acrylic copolymer having an epoxy group on a side chain was sampled and its molecular weight was measured by GPC (gel permeation chromatography, alliance GPC System manufactured by Waters Corporation), and consequently the weight average molecular weigh (Mw) on the polystyrene equivalent basis was 12000.

(2) Preparation of curable resin composition for column spacers

100 parts by weight of the resulting polymer solution (1), 80 parts by weight of caprolactone modified ditrimethylolpropane tetraacrylate (produced by SHIN-NAKAMURA CHEMICAL Co., Ltd., "NK Ester AD-TMP-4CL"), 5 parts by weight of Irgacure907 (produced by Ciba Specialty Chemicals K.K.) and 5 parts by weight of KAYACURE DETX-S (produced by Nippon Kayaku Co., Ltd.) as a photoreaction initiator, respectively, and 8 parts by weight of a thermal crosslinking agent (produced by Asahi Kasei Chemicals Corporation, "Duranate 17B-60PX") were mixed, and to this, 120 parts by weight of diethylene glycol dimethyl ether was further added as a solvent and the mixture was mixed to prepare a curable resin composition for column spacers.

(3) Preparation of column spacers

The obtained curable resin composition for column spacers was applied onto a glass substrate, on which a transparent conductive film was formed, by spin coating and dried at 80˚C for 3 minutes to form a coat. Ultraviolet light was irradiated to the obtained coat at the intensity of 200 $mJ/cm^2$ through a mask having a pattern of dots 30 μm square. After the coat was developed with a 0.04% KOH solution for 60 seconds, it was washed with pure water for 30 seconds to form a pattern of column spacers. Next, the pattern of column spacers was baked at 220˚C for 1 hour. Thereby, a column spacer having a sectional shape of 30 μm by 30 μm (a cross-sectional area 900 $\mu m^2$) and a height of 5.0 μm was obtained.

(4) Production of liquid crystal display element

A sealing agent (produced by Sekisui Chemical Co., Ltd.) was applied onto a glass substrate, on which the obtained column spacer was formed, in the form of a rectangular frame with a dispenser. Subsequently, small droplets of liquid crystal (produced by CHISSO CORPORATION, JC-5004LA) were added dropwise and applied onto the whole surface of the glass substrate within the frame, and on this, other glass substrate was immediately overlaid and ultraviolet light was irradiated to the sealed portion for 60 seconds at the intensity of 50 $mW/cm^2$ using a high-voltage mercury lamp. After this, by annealing the liquid crystal 120˚C for 1 hour and the sealing agent was thermally cured to prepare a liquid crystal display element.

(Experimental Example 16)

100 parts by weight of the solution of an alkali-soluble high polymer compound having a reactive functional group, obtained in Experimental Example 15, 100 parts by weight of caprolactone modified dipentaerythritol tetraacrylate (produced by Nippon Kayaku Co., Ltd., "DPCA-120"), 12 parts by weight of a photoreaction initiator (produced by Ciba Specialty Chemicals K.K., "Irgacure369") and 220 parts by weight of diethylene glycol dimethyl ether as a solvent were mixed to prepare a curable resin composition for column spacers, and further a liquid crystal display element was produced by following the same method as in Experimental Example 15.

(Experimental Example 17)

100 parts by weight of the solution of an alkali-soluble high polymer compound having a reactive functional group, obtained in Example 15, 100 parts by weight of caprolactone modified dipentaerythritol tetraacrylate (produced by KYOEISHA CHEMICAL Co., Ltd., LIGHT-ACRYLATE DPE-6A), 10 parts by weight of a photoreaction initiator (produced by Ciba Specialty Chemicals K.K., "Irgacure369") and 160 parts by weight of diethylene glycol dimethyl ether as

a solvent were mixed to prepare a curable resin composition for column spacers, and further a liquid crystal display element was produced by following the same method as in Experimental Example 15.

(Experimental Example 18)

Into a three liter separable flask equipped with a cooling tube and a stirrer, 60 parts by weight of diethylene glycol dimethyl ether and 2 parts by weight of 2,2-azobis(2,4-dimethyl)valeronitrile were charged as a solvent, and after the mixed solvent was heated to 70˚C in an atmosphere of nitrogen, 12 parts by weight of styrene, 8 parts by weight of methacrylic acid, 20 parts by weight of n-butyl methacrylate and 1 part by weight of n-dodecyl mercaptan were continuously added dropwise over 5 hours while stirring the content of the flask. Then, the mixture was kept at 70˚C for 1 hour and then heated to 90˚C, and polymerization was continued for 3 hours.
The obtained solution of alkali-soluble (meth)acrylic copolymer having an epoxy group on a side chain was sampled and its molecular weight was measured by GPC (gel permeation chromatography, alliance GPC System manufactured by Waters Corporation), and consequently the weight average molecular weigh (Mw) on the polystyrene equivalent basis was 13000.
100 parts by weight of the resulting copolymer solution, 100 parts by weight of caprolactone modified dipentaerythritol tetraacrylate (produced by Nippon Kayaku Co., Ltd., "DPCA-120"), 12 parts by weight of a photoreaction initiator (produced by Ciba Specialty Chemicals K.K., "Irgacure369") and 220 parts by weight of diethylene glycol dimethyl ether as a solvent were mixed to prepare a curable resin composition for column spacers, and further a liquid crystal display element was produced by following the same method as in Experimental Example 15.

(Evaluation)

The column spacers and the liquid crystal display elements obtained in Experimental Examples 15 to 18 were evaluated according to the same methods as described above.
The results are shown in Table 3.
Table 3

| | Column spacer | | | | | | | | Liquid crystal display element | | |
|---|---|---|---|---|---|---|---|---|---|---|---|
| | Deformation by compressing by 15% at 25˚C | | Elastic modulus in deformation by compressing by 15% at 60˚C (GPa) | Elastic modulus in deformation by compressing by 15% at 120˚C (GPa) | Rate of change of elastic modulus after repeating compressing at 25˚C (%) | P value | Coefficient of linear expansion (/˚C) | Resolution | Gap | Gravity defect | Cold bubbling |
| | Elastic modulus (GPa) | Rate of recovery (%) | | | | | | | | | |
| Experimental Example 15 | 0.68 | 70.5 | 0.39 | 0.27 | 3.9 | 5.9 | $2.6 \times 10^{-4}$ | ○ | ○ | ○ | ○ |
| Experimental Example 16 | 0.53 | 66.2 | 0.30 | 0.21 | 5.7 | 7.5 | $3.1 \times 10^{-4}$ | ○ | ○ | ○ | ○ |
| Experimental Example 17 | 1.82 | 92.6 | 1.00 | 0.69 | 9.9 | 11.5 | $6.1 \times 10^{-5}$ | ○ | ○ | × | × |
| Experimental Example 18 | 0.40 | 33.3 | 0.23 | 0.16 | 15.0 | 15.0 | $3.7 \times 10^{-4}$ | ○ | ○ | × | ○ |

(Experimental Example 19)

(1) Polymerization of alkali-soluble carboxyl group-containing high polymer compound

Into a three liter separable flask, 60 parts by weight of diethylene glycol dimethyl ether (DMDG) was charged as a solvent and heated to 90˚C in an atmosphere of nitrogen, and then 12 parts by weight of methyl methacrylate, 8 parts by weight of methacrylic acid, 16 parts by weight of n-butyl methacrylate, 4 parts by weight of 2-hydroxyethyl methacrylate, 2 parts by weight of 2,2-azobis(2,4-dimethyl)valeronitrile and 0.8 parts by weight of n-dodecyl mercaptan were continuously added dropwise over 3 hours. Then, the mixture was kept at 90˚C for 30 minutes and then heated to 105˚C, and polymerization was continued for 3 hours to obtain a solution (solid matter 40% by weight) of an alkali-soluble carboxyl group-containing high polymer compound.
The obtained alkali-soluble carboxyl group-containing high polymer compound was sampled and its molecular weight was measured by gel permeation chromatography (GPC), and consequently the weight average molecular weigh (Mw) was about 20000.

(2) Preparation of curable resin composition for column spacers

100 parts by weight of the resulting solution of an alkali-soluble carboxyl group-containing high polymer compound, 80 parts by weight of caprolactone modified dipentaerythritol hexaacrylate (produced by Nippon Kayaku Co., Ltd., "DPCA-120"), 10 parts by weight of a photoreaction initiator (produced by Ciba Specialty Chemicals K.K. Irgacure907), 10 parts by weight of a photoreaction initiator (produced by Nippon Kayaku Co., Ltd., DETX-S), 8 parts by weight of a thermal crosslinking agent (produced by Asahi Kasei Chemicals Corporation, Duranate 17B-60PX) and 120 parts by weight of diethylene glycol dimethyl ether as a solvent were mixed to prepare a curable resin composition for column spacers.

(3) Preparation of column spacers

The obtained curable resin composition for column spacers was applied onto a glass substrate, on which a transparent conductive film was formed, by spin coating and dried at 80˚C for 3 minutes to obtain a coat. After irradiating the obtained coat with ultraviolet light of 200 mJ/cm$^2$ through a mask having a pattern of dots 30 $\mu$m square, the coat was developed with a 0.04% KOH solution for 60 seconds and washed with pure water for 30 seconds to form a pattern of column spacers. After the pattern of column spacers was baked at 220˚C for 1 hour, each column spacer has a cross-sectional area of 30 $\mu$m by 30 $\mu$m (900 $\mu$m$^2$) and a height of 4.6 $\mu$m.

(4) Production of liquid crystal display element

A sealing agent (produced by Sekisui Chemical Co., Ltd.) was applied onto a glass substrate, on which the obtained column spacer was formed, in the form of a rectangular frame with a dispenser. Subsequently, small droplets of liquid crystal (produced by CHISSO CORPORATION, JC-5004LA) were added dropwise and applied onto the whole surface of the glass substrate within the frame, and on this, other glass substrate was immediately overlaid and ultraviolet light was irradiated to the sealed portion for 60 seconds at the intensity of 50 mW/cm$^2$ using a high-voltage mercury lamp. After this, by annealing the liquid crystal the liquid crystal at 120˚C for 1 hour and the sealing agent was thermally cured to prepare a liquid crystal display element.

(Experimental Example 20)

100 parts by weight of the solution of an alkali-soluble carboxyl group-containing high polymer compound obtained in Experimental Example 19, 80 parts by weight of caprolactone modified ditrimethylolpropane tetraacrylate (produced by SHIN-NAKAMURA CHEMICAL Co., Ltd., NK Ester AD-TMP-4CL), 15 parts by weight of a photoreaction initiator (produced by Ciba Specialty Chemicals K.K., Irgacure369), 8 parts by weight of a thermal crosslinking agent (produced by Asahi Kasei Chemicals Corporation, Duranate E-402-B80T) and 120 parts by weight of diethylene glycol dimethyl ether as a solvent were mixed to prepare a curable resin composition for column spacers.
Column spacers and a liquid crystal display element were obtained by following the same method as in Experimental Example 19 except for using the obtained curable resin composition for column spacers.

(Experimental Example 21)

100 parts by weight of the solution of an alkali-soluble carboxyl group-containing high polymer compound

obtained in Experimental Example 19, 65 parts by weight of caprolactone modified dipentaerythritol hexaacrylate (produced by Nippon Kayaku Co., Ltd., DPCA-120), 15 parts by weight of nonaethylene glycol diacrylate (produced by KYOEISHA CHEMICAL Co., Ltd., 9EG-A), 10 parts by weight of Irgacure907 (produced by Ciba Specialty Chemicals K.K.) and 10 parts by weight of DETX-S (produced by Nippon Kayaku Co., Ltd.) as a photoreaction initiator, 8 parts by weight of a thermal crosslinking agent (produced by Asahi Kasei Chemicals Corporation, Duranate 17B-60PX) and 120 parts by weight of diethylene glycol dimethyl ether as a solvent were mixed to prepare a curable resin composition for column spacers.
Column spacers and a liquid crystal display element were obtained by following the same method as in Experimental Example 19 except for using the obtained curable resin composition for column spacers.

(Experimental Example 22)

100 parts by weight of the solution of an alkali-soluble carboxyl group-containing high polymer compound obtained in Experimental Example 19, 70 parts by weight of caprolactone modified ditrimethylolpropane tetraacrylate (produced by SHIN-NAKAMURA CHEMICAL Co., Ltd., NK Ester AD-TMP-4CL), 10 parts by weight of tetraethylene glycol diacrylate (produced by KYOEISHA CHEMICAL Co., Ltd., LIGHT-ACRYLATE 4EG-A), 15 parts by weight of a photoreaction initiator (produced by Ciba Specialty Chemicals K.K., Irga-cure 369), 8 parts by weight of a thermal crosslinking agent (produced by Asahi Kasei Chemicals Corporation, Duranate 17B-60PX) and 120 parts by weight of diethylene glycol dimethyl ether as a solvent were mixed to prepare a curable resin composition for column spacers.
Column spacers and a liquid crystal display element were obtained by following the same method as in Experimental Example 19 except for using the obtained curable resin composition for column spacers.

(Experimental Example 23)

100 parts by weight of the solution of an alkali-soluble carboxyl group-containing high polymer compound obtained in Experimental Example 19, 70 parts by weight of caprolactone modified ditrimethylolpropane tetraacrylate (produced by SHIN-NAKAMURA CHEMICAL Co., Ltd., NK Ester AD-TMP-4CL), 10 parts by weight of tetraethylene glycol diacrylate (produced by KYOEISHA CHEMICAL Co., Ltd., LIGHT-ACRYLATE 4EG-A), 15 parts by weight of a photoreaction initiator (produced by Ciba Specialty Chemicals K.K., Irgacure369), 8 parts by weight of a thermal crosslinking agent (produced by Asahi Kasei Chemicals Corporation, Duranate E-402-B80T) and 120 parts by weight of diethylene glycol dimethyl ether as a solvent were mixed to prepare a curable resin composition for column spacers. Column spacers and a liquid crystal display element were obtained by following the same method as in Experimental Example 19 except for using the obtained curable resin composition for column spacers.

(Experimental Example 24)

(1) Polymerization of alkali-soluble carboxyl group-containing high polymer compound

Into a three liter separable flask, 60 parts by weight of diethylene glycol dimethyl ether (DMDG) was charged as a solvent and heated to 90˚C in an atmosphere of nitrogen, and then 12 parts by weight of methyl methacrylate, 8 parts by weight of methacrylic acid, 16 parts by weight of n-butyl methacrylate, 4 parts by weight of hydroxyethyl methacrylate, 2 parts by weight of 2,2-azobis(2,4-dimethyl)valeronitrile and 0.8 parts by weight of n-dodecyl mercaptan were continuously added dropwise over 3 hours. Then, the mixture was kept at 90˚C for 30 minutes and then heated to 105˚C, and polymerization was continued for 3 hours to obtain an alkali-soluble carboxyl group-containing high polymer compound.
The obtained alkali-soluble carboxyl group-containing high polymer compound was sampled and its molecular weight was measured by gel permeation chromatography (GPC), and consequently the weight average molecular weigh (Mw) was about 20000.

(2) Preparation of curable resin composition for column spacers

100 parts by weight of the obtained alkali-soluble carboxyl group-containing high polymer compound, 30 parts by weight of dipentaerythritol hexaacrylate (produced by KYOEISHA CHEMICAL Co., Ltd., DPE-6A), 100 parts by weight of nonaethylene glycol diacrylate (produced by KYOEISHA CHEMICAL Co., Ltd., 9EG-A), 10 parts by weight of Irgacure907 (produced by Ciba Specialty Chemicals K.K.) and 10 parts by weight of DETX-S (produced by Nippon Kayaku Co., Ltd.) as a photoreaction initiator, respectively, 12 parts by weight of a thermal crosslinking agent (produced by Asahi Kasei Chemicals Corporation, Duranate 17B-60PX) and 240 parts by weight of diethylene glycol dimethyl ether as a solvent were mixed to prepare a curable resin composition for column spacers.

(3) Preparation of column spacers

The obtained curable resin composition for column spacers was applied onto a glass substrate, on which a transparent conductive film was formed, by spin coating and dried at 80˚C for 3 minutes to obtain a coat. After irradiating the obtained coat with ultraviolet light of 200 mJ/$cm^2$ through a mask having a pattern of dots 30 $\mu$m square, the coat was developed with a 0.04% KOH solution for 60 seconds and washed with pure water for 30 seconds to form a pattern of column spacers. After the pattern of column spacers was baked at 220˚C for 1 hour, each column spacer has a cross-sectional area of 30 $\mu$m by 30 $\mu$m (900 $\mu m^2$) and a height of 4.5 $\mu$m.

(4) Production of liquid crystal display element

A sealing agent (produced by Sekisui Chemical Co., Ltd.) was applied onto a glass substrate, on which the obtained column spacer was formed, in the form of a rectangular frame with a dispenser. Subsequently, small droplets of liquid crystal (produced by CHISSO CORPORATION, JC-5004LA) were added dropwise and applied onto the whole surface of the glass substrate within the frame, and on this, other glass substrate was immediately overlaid and ultraviolet light was irradiated to the sealed portion for 60 seconds at the intensity of 50 mW/$cm^2$ using a high-voltage mercury lamp. After this, by annealing the liquid crystal at 120˚C for 1 hour and the sealing agent was thermally cured to prepare a liquid crystal display element.

(Experimental Example 25)

100 parts by weight of the alkali-soluble carboxyl group-containing high polymer compound obtained in Example 24, 80 parts by weight of pentaerythritol tetraacrylate (produced by KYOEISHA CHEMICAL Co., Ltd., LIGHT-ACRYLATE PE-4A), 140 parts by weight of tetraethylene glycol diacrylate (produced by KYOEISHA CHEMICAL Co., Ltd., LIGHT-ACRYLATE 4EG-A), 30 parts by weight of a photoreaction initiator (produced by Ciba Specialty Chemicals K.K., Irgacure369), 12 parts by weight of a thermal crosslinking agent (produced by Asahi Kasei Chemicals Corporation, Duranate E-402-B80T) and 340 parts by weight of diethylene glycol dimethyl ether as a solvent were mixed to prepare a curable resin composition for column spacers. Column spacers and a liquid crystal display element were obtained by following the same method as in Experimental Example 24 except for using the obtained curable resin composition for column spacers.

(Experimental Example 26)

(1) Polymerization of alkali-soluble carboxyl group-containing high polymer compound

Into a three liter separable flask, 60 parts by weight of diethylene glycol dimethyl ether (DMDG) was charged as a solvent and heated to 90˚C in an atmosphere of nitrogen, and then 13 parts by weight of methyl methacrylate, 7 parts by weight of methacrylic acid, 14 parts by weight of n-butyl methacrylate, 6 parts by weight of 2-ethylhexyl acrylate, 2 parts by weight of 2,2-azobis(2,4-dimethyl)valeronitrile and 0.8 parts by weight of n-dodecyl mercaptan were continuously added dropwise over 3 hours. Then, the mixture was kept at 90˚C for 30 minutes and then heated to 105˚C, and polymerization was continued for 3 hours to obtain an alkali-soluble carboxyl group-containing high polymer compound. The obtained alkali-soluble carboxyl group-containing high polymer compound was sampled and its molecular weight was measured by gel permeation chromatography (GPC), and consequently the weight average molecular weigh (Mw) was about 18000.

(2) Preparation of curable resin composition for column spacers

100 parts by weight of the obtained alkali-soluble carboxyl group-containing high polymer compound, 50 parts by weight of trimethylolpropane triacrylate (produced by SHIN-NAKAMURA CHEMICAL Co., Ltd., NK Ester A-TMPT), 100 parts by weight of tetradecaethylene glycol diacrylate (produced by KYOEISHA CHEMICAL Co., Ltd., LIGHT-ACRYLATE 14EG-A), 20 parts by weight of a photoreaction initiator (produced by Ciba Specialty Chemicals K.K., Irgacure369), 8 parts by weight of a thermal crosslinking agent (produced by Asahi Kasei Chemicals Corporation, Duranate E-402-B80T) and 240 parts by weight of diethylene glycol dimethyl ether as a solvent were mixed to prepare a curable resin composition for column spacers.
Column spacers and a liquid crystal display element were obtained by following the same method as in Experimental Example 24 except for using the obtained curable resin composition for column spacers.

(Experimental Example 27)

100 parts by weight of the solution of an alkali-soluble carboxyl group-containing high polymer compound prepared in Experimental Example 19, 80 parts by weight of dipentaerythritol hexaacrylate (produced by Nippon Kayaku Co., Ltd., DPHA), 10 parts by weight of a photoreaction initiator (produced by Ciba Specialty Chemicals K.K., Irgacure907), 10 parts by weight of a photoreaction initiator (produced by Nippon Kayaku Co., Ltd., DETX-S), 8 parts by weight of a thermal crosslinking agent (produced by Asahi Kasei Chemicals Corporation, Duranate 17B-60PX) and 120 parts by weight of diethylene glycol dimethyl ether as a solvent were mixed to prepare a curable resin composition for column spacers.
Column spacers and a liquid crystal display element were obtained by following the same method as in Experimental Example 19 except for using the obtained curable resin composition for column spacers.

(Experimental Example 28)

100 parts by weight of the solution of an alkali-soluble carboxyl group-containing high polymer compound obtained in Example 19, 80 parts by weight of ditrimethylolpropane tetraacrylate (produced by SHIN-NAKAMURA CHEMICAL Co., Ltd.), 15 parts by weight of a photoreaction initiator (produced by Ciba Specialty Chemicals K.K., Irga-cure 369), 8 parts by weight of a thermal crosslinking agent (produced by Asahi Kasei Chemicals Corporation, Duranate E-402-B80T) and 120 parts by weight of diethylene glycol dimethyl ether as a solvent were mixed to prepare a curable resin composition for column spacers.
Column spacers and a liquid crystal display element were obtained by following the same method as in Experimental Example 19 except for using the obtained curable resin composition for column spacers.

(Experimental Example 29)

100 parts by weight of the solution of an alkali-soluble carboxyl group-containing high polymer compound obtained in Experimental Example 19, 80 parts by weight of caprolactone modified dipentaerythritol hexaacrylate (produced by Nippon Kayaku Co., Ltd., DPCA-120), 10 parts by weight of Irgacure907 (produced by Ciba Specialty Chemicals K.K.) and 10 parts by weight of DETX-S (produced by Nippon Kayaku Co., Ltd.) as a photoreaction initiator and 120 parts by weight of diethylene glycol dimethyl ether as a solvent were mixed to prepare a curable resin composition for column spacers.
Column spacers and a liquid crystal display element were obtained by following the same method as in Experimental Example 19 except for using the obtained curable resin composition for column spacers.

(Experimental Example 30)

100 parts by weight of the alkali-soluble carboxyl group-containing high polymer compound obtained in Example 24, 130 parts by weight of dipentaerythritol hexaacrylate (produced by KYOEISHA CHEMICAL Co., Ltd., DPE-6A), 10 parts by weight of Irgacure907 (produced by Ciba Specialty Chemicals K.K.) and 10 parts by weight of DETX-S (produced by Nippon Kayaku Co., Ltd.) as a photoreaction initiator, 12 parts by weight of a thermal crosslinking agent (produced by Asahi Kasei Chemicals Corporation, Duranate 17B-60PX) and 240 parts by weight of diethylene glycol dimethyl ether as a solvent were mixed to prepare a curable resin composition for column spacers.
Column spacers and a liquid crystal display element were obtained by following the same method as in Experimental Example 24 except for using the obtained curable resin composition for column spacers.

(Experimental Example 31)

100 parts by weight of the alkali-soluble carboxyl group-containing high polymer compound obtained in Example 24, 220 parts by weight of pentaerythritol tetraacrylate (produced by KYOEISHA CHEMICAL Co., Ltd., LIGHT-ACRYLATE PE-4A), 30 parts by weight of a photoreaction initiator (produced by Ciba Specialty Chemicals K.K., Irga-cure 369), 12 parts by weight of a thermal crosslinking agent (produced by Asahi Kasei Chemicals Corporation, Duranate E-402-B80T) and 340 parts by weight of diethylene glycol dimethyl ether as a solvent were mixed to prepare a curable resin composition for column spacers.
Column spacers and a liquid crystal display element were obtained by following the same method as in Experimental Example 24 except for using the obtained curable resin composition for column spacers.

(Experimental Example 32)

100 parts by weight of the alkali-soluble carboxyl group-containing high polymer compound obtained in Experimental Example 24, 160 parts by weight of trimethylolpropane triacrylate (produced by SHIN-NAKAMURA CHEMICAL Co., Ltd., NK Ester A-TMPT), 20 parts by weight of a photoreaction initiator (produced by Ciba Specialty Chemicals K.K., Irgacure369), 12 parts by weight of a thermal crosslinking agent (produced by Asahi Kasei Chemicals Corporation, Duranate E-402-B80T) and 240 parts by weight of diethylene glycol dimethyl ether as a solvent were mixed to prepare a curable resin composition for column spacers.
Column spacers and a liquid crystal display element were obtained by following the same method as in Experimental Example 24 except for using the obtained curable resin composition for column spacers.

(Evaluation)

The column spacers and the liquid crystal display elements obtained in Experimental Examples 19 to 32 were evaluated according to the same methods as described above.
The results are shown in Table 4.
Table 4

| | Column spacer | | | | | | | | Liquid crystal display element | | |
|---|---|---|---|---|---|---|---|---|---|---|---|
| | Deformation by compressing by 15% at 25˚C | | Elastic modulus in deformation by compressing by 15% at 60˚C (GPa) | Elastic modulus in deformation by compressing by 15% at 120˚C (GPa) | Rate of change of elastic modulus after repeating compressing at 25˚C (%) | P value | Coefficient of linear expansion (/˚C) | Resolution | Gap | Gravity defect | Cold bubbling |
| | Elastic modulus (GPa) | Rate of recovery (%) | | | | | | | | | |
| Experimental Example 19 | 0.44 | 71.3 | 0.25 | 0.18 | 2.3 | 6.8 | $3.5 \times 10^{-4}$ | ○ | ○ | ○ | ○ |
| Experimental Example 20 | 0.81 | 75.3 | 0.46 | 0.32 | 4.8 | 6.2 | $2.2 \times 10^{-4}$ | ○ | ○ | ○ | ○ |
| Experimental Example 21 | 0.66 | 65.3 | 0.38 | 0.26 | 3.8 | 8.3 | $2.7 \times 10^{-4}$ | ◎ | ○ | ○ | ○ |
| Experimental Example 22 | 0.61 | 63.3 | 0.35 | 0.24 | 3.5 | 8.2 | $2.8 \times 10^{-4}$ | ◎ | ○ | ○ | ○ |
| Experimental Example 23 | 0.71 | 69.5 | 0.39 | 0.26 | 4.1 | 8.5 | $2.5 \times 10^{-4}$ | ◎ | ○ | ○ | ○ |
| Experimental Exemple 24 | 0.80 | 65.3 | 0.45 | 0.31 | 4.7 | 5.0 | $2.3 \times 10^{-4}$ | ○ | ○ | ○ | ○ |
| Experimental Example 25 | 0.90 | 69.8 | 0.50 | 0.34 | 5.4 | 7.8 | $2.0 \times 10^{-4}$ | ○ | ○ | ○ | ○ |
| Experimental Example 26 | 0.58 | 63.5 | 0.33 | 0.23 | 3.3 | 6.9 | $2.9 \times 10^{-4}$ | ○ | ○ | ○ | ○ |
| Experimental Example 27 | 1.85 | 90.5 | 1.01 | 0.70 | 11.7 | 13.0 | $6.0 \times 10^{-5}$ | ○ | ○ | × | × |
| Experimental Example 28 | 1.70 | 88.3 | 0.90 | 0.66 | 10.7 | 9.4 | $7.5 \times 10^{-5}$ | ○ | ○ | × | × |
| Experimental Example 29 | 0.44 | 40.6 | 0.25 | 0.20 | 13.6 | 15.9 | $3.5 \times 10^{-4}$ | ○ | ○ | × | ○ |

(continued)

| | Column spacer | | | | | | | | Liquid crystal display element | | |
|---|---|---|---|---|---|---|---|---|---|---|---|
| | Deformation by compressing by 15% at 25°C | | Elastic modulus in deformation by compressing by 15% at 60°C (GPa) | Elastic modulus in deformation by compressing by 15% at 120°C (GPa) | Rate of change of elastic modulus after repeating compressing at 25°C (%) | P value | Coefficient of linear expansion (/°C) | Resolution | Gap | Gravity defect | Cold bubbling |
| | Elastic modulus (GPa) | Rate of recovery (%) | | | | | | | | | |
| Experimental Example 30 | 1.88 | 93.8 | 1.03 | 0.71 | 11.9 | 14.4 | $5.5 \times 10^{-5}$ | ○ | ○ | × | × |
| Experimental Example 31 | 2.06 | 88.7 | 1.10 | 0.76 | 13.1 | 11.7 | $3.6 \times 10^{-5}$ | ○ | ○ | × | × |
| Experimental Example 32 | 1.75 | 88.7 | 0.96 | 0.65 | 11.1 | 11.4 | $6.9 \times 10^{-5}$ | ○ | ○ | x | × |

(Experimental Example 33)

(1) Synthesis of alkali-soluble (meth)acrylic copolymer

Into a three liter separable flask, 60 parts by weight of diethylene glycol dimethyl ether was charged as a solvent and heated to 90˚C in an atmosphere of nitrogen, and then a mixture comprising of 10 parts by weight of methyl methacrylate, 8 parts by weight of methacrylic acid, 22 parts by weight of n-butyl methacrylate, 2 parts by weight of 2,2-azobis(2,4-dimethyl)valeronitrile and 0.8 parts by weight of n-dodecyl mercaptan was added dropwise over 3 hours. Then, kept at 90˚C for 30 minutes and then heated to 105˚C, and polymerization was continued for 3 hours to obtain a polymer solution.

(2) Preparation of curable resin composition for column spacers

100 parts by weight of the prepared copolymer solution, 80 parts by weight of caprolactone modified dipentaerythritol hexaacrylate (produced by Nippon Kayaku Co., Ltd., "DPCA-120"), 15 parts by weight of a photoreaction initiator (produced by Ciba Specialty Chemicals K.K., "Irgacure369") and 15 parts by weight of a thermal crosslinking agent polyfunctional epoxy compound (produced by Japan Epoxy Resins Co., Ltd., "EPICOAT 815") were mixed, and further to this, 120 parts by weight of diethylene glycol dimethyl ether as a diluent was added and the mixture was mixed to prepare a curable resin composition for column spacers.

(3) Preparation of column spacers

The obtained curable resin composition for column spacers was applied onto a glass substrate, on which a transparent conductive film was formed, by spin coating and dried at 80˚C for 3 minutes to obtain a coat. Ultraviolet light was irradiated to the obtained coat at the intensity of 200 $mJ/cm^2$ through a mask having a pattern of dots 30 μm square. After the coat was developed with a 0.04% KOH solution for 60 seconds, the coat was washed with pure water for 30 seconds to form a pattern of column spacers. Next, the pattern of column spacers was baked at 220˚C for 1 hour. Thereby, a column spacer having a sectional shape of 30 μm by 30 μm (a cross-sectional area 900 $\mu m^2$) and a height of 5.0 μm was obtained.

(4) Production of liquid crystal display element

A sealing agent (produced by Sekisui Chemical Co., Ltd.) was applied onto a glass substrate, on which the obtained column spacer was formed, in the form of a rectangular frame with a dispenser. Subsequently, small droplets of liquid crystal (produced by CHISSO CORPORATION, JC-5004LA) were added dropwise and applied onto the whole surface of the glass substrate within the frame, and on this, other glass substrate was immediately overlaid and ultraviolet light was irradiated to the sealed portion for 60 seconds at the intensity of 50 $mW/cm^2$ using a high-voltage mercury lamp. After this, by annealing the liquid crystal at 120˚C for 1 hour and the sealing agent was thermally cured to prepare a liquid crystal display element.

(Experimental Example 34)

100 parts by weight of the solution of an alkali-soluble high polymer compound obtained in Experimental Example 33, 80 parts by weight of caprolactone modified ditrimethylolpropane tetraacrylate (produced by SHIN-NAKAMURA CHEMICAL Co., Ltd., "NK Ester AD-TMP-4CL"), 15 parts by weight of a photoreaction initiator (produced by Ciba Specialty Chemicals K.K., "Irgacure369"), 15 parts by weight of a thermal crosslinking agent (produced by Japan Epoxy Resins Co., Ltd., "EPICOAT 815") and 120 parts by weight of diethylene glycol dimethyl ether as a solvent were mixed to prepare a curable resin composition for column spacers, and further a liquid crystal display element was produced by following the same method as in Experimental Example 33.

(Experimental Example 35)

100 parts by weight of the solution of an alkali-soluble high polymer compound obtained in Example 33, 60 parts by weight of caprolactone modified dipentaerythritol hexaacrylate (produced by Nippon Kayaku Co., Ltd., "KAYARAD DPCA-120"), 20 parts by weight of 1,9-nonaethylene glycol diacrylate (produced by KYOEISHA CHEMICAL Co., Ltd., "LIGHT-ACRYLATE 9EG-A"), 15 parts by weight of a photoreaction initiator (produced by Ciba Specialty Chemicals K.K., "Irgacure369"), 15 parts by weight of a thermal crosslinking agent (produced by Japan Epoxy Resins Co., Ltd., "EPICOAT 815") and 120 parts by weight of diethylene glycol dimethyl ether as a solvent were mixed to prepare

a curable resin composition for column spacers, and further a liquid crystal display element was produced by following the same method as in Experimental Example 33.

(Experimental Example 36)

100 parts by weight of the copolymer solution prepared in Experimental Example 33, 80 parts by weight of caprolactone modified dipentaerythritol hexaacrylate (produced by Nippon Kayaku Co., Ltd., "KAYARAD DPCA-120"), 15 parts by weight of a photoreaction initiator (produced by Ciba Specialty Chemicals K.K., "Irgacure369") and 120 parts by weight of diethylene glycol dimethyl ether as a diluent were added and the mixture was mixed to prepare a curable resin composition for column spacers, and further a liquid crystal display element was produced by following the same method as in Experimental Example 33.

(Experimental Example 37)

100 parts by weight of the copolymer solution prepared in Experimental Example 33, 80 parts by weight of dipentaerythritol hexaacrylate (produced by KYOEISHA CHEMICAL Co., Ltd., "LIGHT-ACRYLATE DPE-6A"), 15 parts by weight of a photoreaction initiator (produced by Ciba Specialty Chemicals K.K., "Irgacure369"), 15 parts by weight of a thermal crosslinking agent (produced by Japan Epoxy Resins Co., Ltd., "EPICOAT 815") and 120 parts by weight of diethylene glycol dimethyl ether as a diluent were added and mixed to prepare a curable resin composition for column spacers, and further a liquid crystal display element was produced by following the same method as in Experimental Example 33.

(Evaluation)

The column spacers and the liquid crystal display elements obtained in Experimental Examples 33 to 37 were evaluated according to the same methods as described above.
The results are shown in Table 5.
Table 5

| | Column spacer | | | | | | | | Liquid crystal display element | | |
|---|---|---|---|---|---|---|---|---|---|---|---|
| | Deformation by compressing by 15% at 25°C | | Elastic modulus in deformation by compressing by 15% at 60°C (GPa) | Elastic Rate of modulus in change of deformation elastic modulus by compressing after repeating by 15% at compressing 120°C (GPa) at 25°C (%) | | P value | Coefficient of linear expansion (/°C) | Resolution | Gap | Gravity defect | Cold bubbling |
| | Elastic modulus (GPa) | Rate of recovery (%) | | | | | | | | | |
| Experimental Example 33 | 0.49 | 68.8 | 0.28 | 0.20 | 4.1 | 6.1 | $3.3 \times 10^{-4}$ | ○ | ○ | ○ | ○ |
| Experimental Example 34 | 0.63 | 70.8 | 0.36 | 0.25 | 3.6 | 6.3 | $2.8 \times 10^{-4}$ | ○ | ○ | ○ | ○ |
| Experimental Example 35 | 0.44 | 60.2 | 0.25 | 0.18 | 4.5 | 6.8 | $3.5 \times 10^{-4}$ | ◎ | ○ | ○ | ○ |
| Experimental Example 36 | 0.46 | 36.7 | 0.26 | 0.18 | 10.9 | 15.2 | $3.4 \times 10^{-4}$ | ○ | ○ | × | ○ |
| Experimental Example 37 | 1.68 | 92.1 | 0.91 | 0.62 | 10.6 | 11.9 | $7.8 \times 10^{-5}$ | ○ | ○ | × | × |

Industrial Applicability

In accordance with the present invention, it is possible to provide the column spacer capable of forming a liquid crystal display element which does not produce the color irregularity due to gravity defect and the cold bubbling and exhibits the high durability when the column spacer is used as a spacer for maintaining a gap between two glass substrates at a constant distance in a liquid crystal display element, the liquid crystal display element using the column spacers and the curable resin composition for column spacers from which the column spacer can be produced.

## Claims

1. A column spacer for maintaining a gap between two glass substrates at a constant distance in a liquid crystal display element,
which comprises an elastic modulus of 0.2 to 1.0 GPa in compressing by 15% at 25°C.

2. The column spacer according to claim 1,
wherein an elastic modulus in compressing by 15% at 60°C is 0.13 to 0.65 GPa.

3. The column spacer according to claim 1,
wherein an elastic modulus in compressing by 15% at 120°C is 0.1 to 0.5 GPa.

4. The column spacer according to claim 1,
wherein a rate of change of the elastic modulus in the fifth compression relative to the elastic modulus in the first compression is 5% or less when a compression test of compressing by 15% at 25°C is performed repeatedly.

5. The column spacer according to claim 1,
wherein an initial compression elastic modulus $E_{25}$ in compressing by 15% at 25°C and a compression elastic modulus $E_{120}$ in compressing by 15% at 25°C after compressing by 15% at 120°C satisfy the relationship of the following equation (1):

$$\{(E_{120}-E_{25})/E_{25}\}\times 100 \leq 10 \qquad (1).$$

6. The column spacer according to claim 1,
wherein a rate of recovery in deforming by compressing by 15% at 25°C is 70% or more.

7. A liquid crystal display element obtained by using the column spacer according to claim 1, 2, 3, 4, 5 or 6.

8. A column spacer for maintaining a gap between two glass substrates at a constant distance in a liquid crystal display element,
which comprises a coefficient of linear expansion of $1\times10^{-4}$ to $5\times10^{-4}$/°C at a temperature range of 25 to 100°C.

9. A liquid crystal display element obtained by using the column spacer according to claim 8.

10. A curable resin composition for a column spacer to be used for producing a column spacer of a liquid crystal display element,
which comprises an alkali-soluble high polymer compound having a reactive functional group, a compound having a difunctional or more functional unsaturated bond and a photoreaction initiator.

11. The curable resin composition for column spacers according to claim 10,
wherein an amount of the compound having a difunctional or more functional unsaturated bond to be mixed is 100 to. 900 parts by weight with respect to 100 parts by weight of the alkali-soluble high polymer compound having a reactive functional group.

12. The curable resin composition for a column spacer according to claim 10,
wherein the alkali-soluble high polymer compound having a reactive functional group is an alkali-soluble (meth) acrylic copolymer having a (meth)acrylic group and a carboxyl group on a side chain.

**13.** The curable resin composition for a column spacer according to claim 12, wherein the alkali-soluble (meth)acrylic copolymer having a (meth)acrylic group and a carboxyl group on a side chain is a polymer having a main chain comprising of at least a constituent unit having an acid functional group and a constituent unit having a hydroxyl group, and a radical polymerizable group-containing isocyanate compound is coupled to at least a part of the acid functional group in the form of an amide bond and/or coupled to at least a part of the hydroxyl group in the form of a urethane bond via an isocyanate group of the isocyanate compound, respectively.

**14.** The curable resin composition for a column spacer according to claim 12, wherein the alkali-soluble (meth)acrylic copolymer having a (meth)acrylic group and a carboxyl group on a side chain is a copolymer consisting of each structural unit expressed by the following formulas (1a), (1b), (1c), (1d) and (1e);

[Chem. 1]

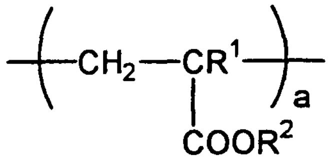

(1 a)

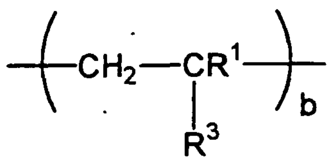

(1 b)

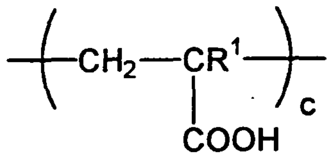

(1 c)

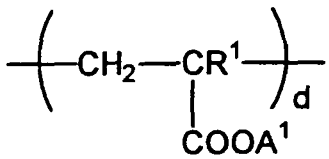

(1 d)

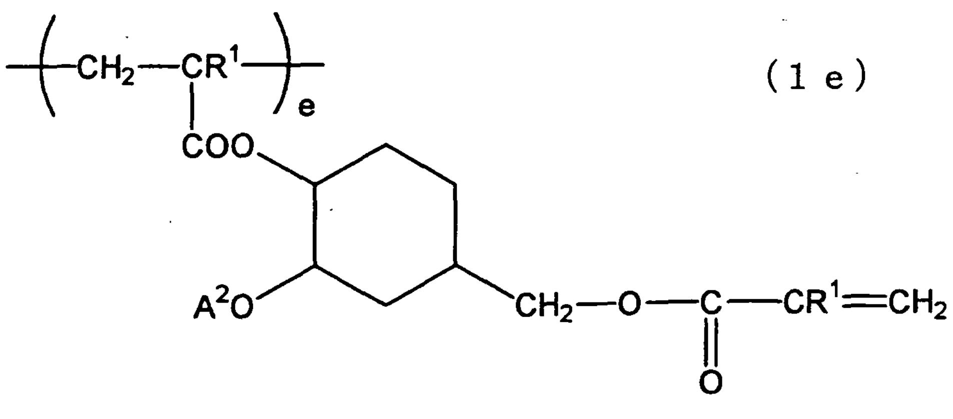

(1 e)

in the formulas (1a), (1b), (1c), (1d) and (1e), $A^1$ and $A^2$ represent a hydrogen or a following formulas (2a), (2b), (2c) or (2d), and when either of $A^1$ or $A^2$ is a hydrogen, the other is any one of the following formulas (2a), (2b), (2c) and (2d), and $R^1$ represents a hydrogen and/or a methyl group, $R^2$ represents an alkyl group, a phenyl group, a phenyl group containing an alkyl group or an alkoxy group, a hydroxyalkyl group or an alicyclic hydrocarbons, $R^3$ represents a nitrile group or a phenyl group, $R^4$ represents an alkyl group, a hydroxyalkyl group or radical polymerizable group-containing aliphatic hydrocarbons, and a, b, c, d and e represent mole ratios (%) of the respective components, and when a+b+c+d+e = 100, a, b and d are 0 to 90, c is 5 to 50 and e is 5 to 60;

[Chem. 2]

$A^1, A^2$ : 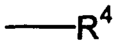 (2 a)

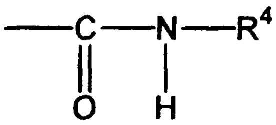 (2 b)

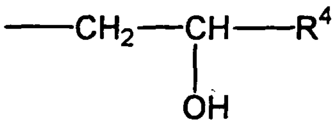 (2 c)

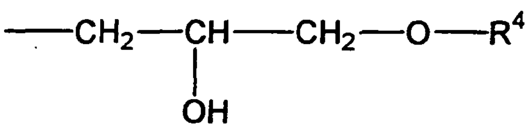 (2 d)

**15.** The curable resin composition for a column spacer according to claim 14, wherein $A^1$ and/or $A^2$ is expressed by the formula (2b).

**16.** The curable resin composition for a column spacer according to claim 14, wherein $A^1$ and/or $A^2$ is expressed by the formula (2b) and $R^4$ in the formula (2b) is a radical polymerizable group-containing aliphatic hydrocarbon.

**17.** The curable resin composition for a column spacer according to claim 14, wherein $A^1$ and $A^2$ are expressed by the formula (2c) or (2d).

**18.** The curable resin composition for a column spacer according to claim 10, wherein the alkali-soluble high polymer compound having a reactive functional group is a copolymer containing unsaturated carboxylic acid and/or unsaturated carboxylic anhydride, and a blocked isocyanate group-containing unsaturated compound.

**19.** The curable resin composition for a column spacer according to claim 18, wherein the copolymer containing unsaturated carboxylic acid and/or unsaturated carboxylic anhydride, and a blocked isocyanate group-containing unsaturated compound, further contains a hydroxyl group-containing unsaturated compound.

**20.** The curable resin composition for a column spacer according to claim 10, wherein the alkali-soluble high polymer compound having a reactive functional group is an alkali-soluble (meth) acrylic copolymer having an epoxy group on a side chain.

**21.** The curable resin composition for a column spacer according to claim 10, wherein the compound having a difunctional or more functional unsaturated bond is a trifunctional or more functional caprolactone modified (meth)acrylate compound.

**22.** The curable resin composition for column spacers according to claim 10, wherein the compound having a difunctional

or more functional unsaturated bond is a compound having a polymerizable unsaturated bond and having a polyethylene glycol skeleton.

**23.** The curable resin composition for a column spacer according to claim 10, which further comprises a thermal cross-linking agent having a functional group capable of doing cross-linking reaction with the alkali-soluble high polymer compound having a reactive functional group.

**24.** The curable resin composition for column spacers according to claim 23, wherein the thermal cross-linking agent having a functional group capable of doing cross-linking reaction with the alkali-soluble high polymer compound having a reactive functional group is a thermal cross-linking agent having two or more blocked isocyanate groups.

**25.** The curable resin composition for a column spacer according to claim 23, wherein the thermal cross-linking agent having a functional group capable of doing cross-linking reaction with the alkali-soluble high polymer compound having a reactive functional group is a thermal cross-linking agent having two or more epoxy groups.

**26.** A column spacer, obtained by using the curable resin composition for a column spacer according to claim 10, 11, 12, 13, 14, 15, 16, 17, 18, 19, 20, 21, 22, 23, 24 or 25.

**27.** A liquid crystal display element, obtained by using a column spacer according to claim 26.

## INTERNATIONAL SEARCH REPORT

International application No.
PCT/JP2005/001722

A. CLASSIFICATION OF SUBJECT MATTER
Int.Cl$^7$ G02F1/1339

According to International Patent Classification (IPC) or to both national classification and IPC

B. FIELDS SEARCHED

Minimum documentation searched (classification system followed by classification symbols)
Int.Cl$^7$ G02F1/1339

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2005 |
| Kokai Jitsuyo Shinan Koho | 1971-2005 | Toroku Jitsuyo Shinan Koho | 1994-2005 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X | JP 2001-106765 A (Dainippon Printing Co., Ltd.), 17 April, 2001 (17.04.01), & EP 1141063 A | 10,12,13,22, 26,27 |
| A | JP 2001-13506 A (Matsushita Electric Industrial Co., Ltd.), 19 January, 2001 (19.01.01), & EP 1048972 A2 | 1-27 |
| A | JP 2003-15138 A (Toppan Printing Co., Ltd.), 15 January, 2003 (15.01.03), (Family: none) | 1-27 |

☐ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 07 June, 2005 (07.06.05) | 28 June, 2005 (28.06.05) |
| Name and mailing address of the ISA/ Japanese Patent Office | Authorized officer |
| Facsimile No. | Telephone No. |

Form PCT/ISA/210 (second sheet) (January 2004)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 11133600 A
- JP 2001091954 A
- JP 2001 A
- JP 106765 A